(19) Europäisches Patentamt
European Patent Office
Office européen des brevets

(11) Publication number: **0 216 513**
**A2**

(12) # EUROPEAN PATENT APPLICATION

(21) Application number: 86306511.6

(51) Int. Cl.4: C 23 C 18/24

(22) Date of filing: 21.08.86

(30) Priority: 22.08.85 US 768476

(43) Date of publication of application:
01.04.87 Bulletin 87/14

(84) Designated Contracting States:
AT BE CH DE FR GB IT LI LU NL SE

(71) Applicant: UNION CARBIDE CORPORATION
39 Old Ridgebury Road
Danbury Connecticut 06817(US)

(72) Inventor: Rimsa, Stephen Benedict
175 Welsh Road Lebanon
New Jersey 08833(US)

(74) Representative: Baverstock, Michael George Douglas et al,
BOULT, WADE & TENNANT 27 Furnival Street
London, EC4A 1PQ(GB)

(54) **Treatment of drilled copper-clad thermoplastic laminates.**

(57) Copper clad thermoplastic laminates having holes drilled therein may be treated to render the hole walls thereof adherently electrolessly platable by immersing the laminate in concentrated sulfuric acid, optionally containing an oxidizing agent, and then removing sulfuric acid from the laminate thus treated. As oxidizing agent, ammonium persulfate is preferred.

EP 0 216 513 A2

Croydon Printing Company Ltd.

# TREATMENT OF DRILLED COPPER CLAD THERMOPLASTIC LAMINATES

This invention is directed to a method of treating a copper clad thermoplastic laminate having holes drilled therein by immersing the laminate in concentrated sulphuric acid or sulphuric acid containing a dissolved oxidant, ammonium persulfate being the preferred oxidant, and removing sulfuric acid from the laminate thus treated. The invention makes it possible to deposit electroless metal plating essentially free of defects on the hole walls.

A wide variety of thermoplastic polymers have been used as substrates for electrical components, such as in circuit board laminates. These substrates have been molded from, for example, polyphenyleneoxide, polyphenylenesulfide, polyimides and polyarylethersulfones. U.S. Patent Application Serial No. 516,863, filed in the name of J.E. Harris et al, on July 25, 1983, titled "A Composition Useful For Making Circuit Board Substrates and Electrical Connectors" (commonly assigned), describes a composition useful for making circuit board substrates and electrical connectors comprising a blend of a poly(aryl ether sulfone) and a polyarylsulfone. U.S. Patent Application Serial No. 566,298, filed in the name of H. Chao et al, on December 28, 1983, titled "A Polymer Useful For Molding Into A Circuit Board Substrate" (commonly

assigned), describes a select poly(aryl ether sulfone) which is useful for molding into circuit board substrates. U.S. Patent Application Serial No. 448,376, filed in the name of J.E. Harris, on December 9, 1982, titled "A Composition Useful For Making Circuit Board Substrates And/Or Electrical Connectors" (commonly assigned), describes a composition comprising a blend of a poly(aryl ether), a poly(etherimide) polymer, a fiber and a filler which is useful for making circuit board substrates and/or electrical connectors.

U.S. Patent Application Serial No. 593,046, filed in the name of S. Rimsa on March 26, 1984, titled "Method of Restoring the Surface of a Thermoplastic Substrate" (commonly assigned) describes a method for restoring the surface of a substrate molded from a thermoplastic polymer after its surface has undergone conditioning by a strong oxidizing or reducing agent and/or mechanical abrasion, by exposing the surface of the substrate to solvent vapors for a period of time sufficient to restore the surface to essentially that before conditioning.

Circuit boards presently in use are copper clad thermoset or thermoplastic laminates. A thermoplastic copper clad laminate usually comprises a shaped (e.g., as a thin, flat board) thermoplastic electrically insulating (dielectric) core substrate having laminated on one and usually on both faces a copper sheet which provides the surface for the circuit. The size of the copper cladding depends on the size of the circuit to be printed thereon. A

thermoset copper clad laminate comprises a shaped thermoset electrically insulating (dielectric) core having laminated on one or both faces a copper sheet, wherein the thermoset insulating core is itself usually a (laminated) compound structure. Holes are drilled through the copper clad laminate, ultimately to be electrolessly through-hole metal plated, usually copper plated, to provide electrical contact between the two board faces.

Whether a thermoset or thermoplastic substrate is employed, it is desirable that the electroless metal plating cover completely and adhere evenly to the hole wall, i.e., that it not suffer from voiding and nodulation which can cause hole wall pullaway. Unless the holes are treated to render the walls electrolessly platable, however, the resultant through-hole plating exhibits numerous defects or discontinuities in the form of bubbles, blisters, and voids. In egregious cases it is possible for electrolessly plated metal to simply flake off the wall under no-load conditions, leaving voids in the plating. Such defects in the plated metal are serious impediments to producing quality boards and hence are unacceptable. Problems stemming from the defects are evident during the through-hole plating of thermoplastic copper clad polysulfone, polyether sulfone, and polyetherimide, for example.

The bulk of the prior art related to rendering drilled holes in circuit boards electrolessly platable involves circuit boards fabricated from thermosetting resins, as opposed to

thermoplastic resins, because the use of thermoplastic resin substrates to make boards is a comparatively recent development. When a thermoset printed wiring laminate is drilled, the resulting hole wall is usually coated by a thin film of degraded polymer which develops through decomposition of the polymeric board material by heat generated during the drilling process. The film of decomposed polymer is termed "drill smear". The smear covered hole wall is extremely difficult to activate (i.e. render catalytic to electroless deposition) and electrolessly copper plate.

Concentrated sulfuric acid has been tried as a candidate for drill smear removal from thermoset circuit boards (such as epoxy glass multilayer board which is presently widely used), but the prior art teaches that it does not remove drill smear adequately, see for example Barmuta, PC FAB, April 1984, pp. 50-56. The Barmuta article discloses that although concentrated sulfuric acid can dissolve thermoset (e.g., epoxy glass) drill smear, it does not remove it sufficiently from the drill hole and subsequent water rinsing leaves behind a softened smear (e.g., epoxy) residue on the hole wall. The smear residue can affect hole wall reliability, manifesting itself as hole wall pullaway, defined in the Barmuta article as the adhesive and/or cohesive failure of electroless copper and the hole wall inner substrate material. The article thus notes that the residue can be a cause of voiding and nodulation.

Doubrava in PC FAB, August, 1985, pp. 14-29 notes that there are many different sulfuric acid

desmear processes in wide use and that many suffer from poor hole wall adhesion. The article notes that the cause of this poor adhesion may be visualized microscopically by glazed epoxy surfaces or by the presence of desmear residues, and that blistering or epoxy voiding may be seen as a result. Accordingly, the article also notes that post-desmear treatments such as alkaline/solvent cleaners or alkaline permanganate are of great help.

Present techniques for removing drill smear from holes in copper clad thermoset laminates therefore employ up to several separate smear removal steps in addition to treatment with concentrated sulfuric acid, which steps may include acid and/or caustic treatment coupled with treatment in an oxidizing bath based, for example, on permangate or chromate/chromic acid. The need for using different chemical environments and multi-step treatments appears ultimately related to the fact that sulfuric acid alone is simply inadequate to remove (thermoset) drill smear from holes in thermoset circuit board laminates, as taught in the Barmuta and Doubrava articles, supra.

As noted above, holes drilled in circuit boards and laminates fabricated from thermoplastic resins are also difficult to plate electrolessly. Although hole wall unreliability in thermoplastic boards is known, it is not nearly as well understood as in the case of thermoset boards, and there is little if any information which provides insight into the problem. A method for rendering holes drilled in thermoplastic circuit board laminates

electrolessly platable would thus be a useful addition to the thermoplastic circuit board art, particularly if the method was simple and inexpensive.

This invention provides a method of treating a copper clad thermoplastic laminate having holes drilled therein, comprising immersing the drilled laminate in concentrated sulfuric acid for a time sufficient to allow subsequent adherent electroless metal deposition on the hole walls thereof, and removing sulfuric acid from the laminate thus treated.

"Concentrated sulfuric acid" is intended to denote sulfuric acid having an acid concentration of at least about 92% and above.

"Drilled" refers to any method of hole formation in copper clad thermoplastic laminates, including mechanical formation (i.e. using drill bits, punch presses, and so forth), optical formation (i.e. using lasers), high pressure water jets, and in-mold hole fabrication by injection molding wherein core pins are utilized to create through holes.

"Subsequent" refers, of course, to the fact that electroless metal deposition is effected at some time following immersion in sulfuric acid and removal of the acid. Plating will generally be conducted following immersion in concentrated acid, acid removal, and a sequence of chemical operations which catalytically activate the hole walls to electroless deposition, as known in the art.

The present invention is predicated on the surprising finding that exposure of holes drilled in thermoplastic substrates or copper clad laminates (herein also referred to as "thermoplastic holes") to concentrated sulfuric acid results in hole walls which are capable of being electrolessly metal plated with the plating exhibiting freedom from blistering, flaking, voiding, nodulation, and other defects.

The invention is unexpected in view of the prior art disclosure that thermoset drill-smeared holes treated with sulfuric acid are generally not adequate for plating and, consequently, that separate additional chemical treatment steps prior to catalytic activation of the hole wall are necessary to achieve hole walls which are free of voiding and nodulation in electroless platings deposited thereon.

Additional chemical treatment steps prior to catalytic activation of the hole wall are, of course, feasible in the present invention, but are not strictly needed to obtain platable thermoplastic hole walls.

While not wishing to be bound by theory, it is believed that concentrated sulfuric acid acts on thermoplastic holes at least in part by a different mechanism than that by which it acts on thermoset holes. Sulfuric acid acts in large part by dissolving thermoset drill smear, albeit inadequately (Barmuta, supra). Although digestion of thermoplastic debris by sulfuric acid can occur in the case of thermoplastic holes, it is believed

that a different and important phenomenon is further involved. That is, it is believed that a topographical change is effected on the hole wall whereby the wall is microcrazed, providing an extensive network of cracks, chasms, and fissures which gives the appearance under a scanning electron microscope similar to mud cracking in a sun-baked dried up lake bed. Thus it is believed that exposure to sulfuric acid "ruggedizes" the hole wall, with the microcrazing providing a multiplicity of sites which securely anchor the electroless plating subsequently deposited. By ruggedizing the hole wall, the sulfuric acid is also believed to advantageously increase the hole wall surface area and thereby provide greater access to an electroless plating solution.

A copper clad thermoplastic laminate is conventionally prepared via press laminating, under heat and pressure, an appropriately anodized copper foil to a high $T_g$ thermoplastic core (polysulfone, polyethersulfone, polyarylethersulfone, polyetherimide, etc.). Copper clad thermoplastic laminates can also be produced by in-mold applique techniques whereby copper foil inserts are placed into a mold prior to introduction of a thermoplastic which will serve as the (core) dielectric layer, or by extrusion lamination whereby the dielectric thermoplastic core is laminated in-line with copper foil, all such techniques for forming copper clad "laminates" being within the scope of this invention. The laminated construction is sheared into panels of appropriate size and drilled with the desired printed circuit hole pattern.

The drilled copper clad thermoplastic laminate is treated by immersing it in concentrated sulfuric acid, advantageously with agitation to ensure through-hole acid penetration. The time of immersion is sufficient to allow subsequent adherent deposition of electroless metal, "adherent" meaning that the plating is relatively much more unsusceptible to plating defects than an untreated laminate. Agitation may be achieved mechanically as well known in the art by racking the boards and drawing the racks through an acid bath. The acid may then be removed, for example, by soaking or rinsing the boards with water, advantageously with agitation, or, alternatively, by neutralizing the acid by soaking or washing the board with a mild (typically 0.1-5 Normal) solution of a base such as an alkali metal (e.g., sodium, lithium or potassium) hydroxide or an alkali metal carbonate or bicarbonate. Then, typically following a catalytic activation sequence as known in the art, the board may be electrolessly through-hole metal plated to yield platings substantially free of nodulation, blistering, and other defects.

The electroless metal platings referred to herein and the chemical solutions used to deposit them are well known in the art and form no part of this invention. Generally electroless copper plating solutions are preferred although other metals such as cobalt, gold, or nickel may also be employed if desired and are intended to be within the scope of the invention. Any conventional plating solution may be used, such as those

disclosed, for example, in Lowenheim, Modern Electroplating and A. Kenneth Graham, Handbook of Electroplating Engineering.

In a further aspect of the invention, it has been found that dissolving an oxidizing agent in concentrated sulfuric acid aids in rendering thermoplastic hole walls platable. It is believed the oxidant aids concentrated sulfuric acid treatment at least partially by oxidizing any dissolved or digested degraded polymer, thereby purging the sulfuric acid and preventing it from gradually becoming saturated with digested polymer and reduced in treatment capability, and also by enhancing the ruggedizing effect of the hole wall by concentrated sulfuric acid.

Any oxidizing agent compatible with concentrated sulfuric acid may be employed although ammonium persulfate is preferred due to its relatively low environmental impact. Other oxidizing agents such as alkali metal chromates and dichromates and peroxides such as hydrogen peroxide can also be used.

Exposure of the drilled copper clad laminate to concentrated $H_2SO_4$ for between about 0.5 and about 20 minutes at a temperature between about 10°C and about 50°C, preferably about 35-40°C, is preferred to render hole walls platable, with about 3 minutes exposure being most preferred. Durations of exposure and temperatures outside the above preferred ranges may also be used, but without substantial advantage. Exposure times longer than about 20 minutes generally result in little if any

further enhancement of hole wall topography and subsequent platability, although longer durations with very cold sulfuric acid may be useful. Temperatures much above 50°C may increase the hazards of handling concentrated sulfuric acid.

The dissolution of an oxidizing agent in a preferred amount between about 0.05 and about 1.0 moles per liter of concentrated sulfure acid has been found to accelerate considerably the rate of topographical ruggedization. The most preferred mixture contains between about 0.1 and about 0.5 moles of ammonium persulfate per liter of concentrated sulfuric acid. Preferred treatment periods range from about 15 seconds to about 10 minutes with 1 to 3 minutes treatment being most preferred. The preferred temperature range is again about 10°C to about 50°C, with the most preferred range being about 35°C to about 40°C. Exposure times outside the preferred exposure time and temperature ranges are feasible.

The copper clad thermoplastic laminate following treatment is hydrophillic in nature and easily wettable. The treated laminate may be subjected to standard activation chemistry available from known suppliers (such as Shipley, Inc., MacDermid, Inc., or Enthone, Inc.) to render the hole walls catalytic to electroless deposition.

The thermoplastic polymers which may be used herein include a polyarylate, a polyetherimide, a polyester polymer, an aromatic polycarbonate, including polyestercarbonate, a poly(aryl ether), a poly(aryl ether sulfone) and the like, or

combinations thereof, including blends. These polymers may, individually or as blended mixtures, be further blended with one or more additional components selected from polyamides, polyphenylenesulfides, and poly(aryl ether ketones), the additional components being present in an amount up to about 50 wt. % based on the weight of the blend.

## BRIEF DESCRIPTION OF THE FIGURES

FIGURES 1-5 are scanning electron micrographs (SEM) of hole walls in drilled copper clad polysulfone. The SEMs are more fully discussed in the examples.

FIGURE 1a is an X100 magnification SEM of an untreated hole wall.

FIGURE 1b is the untreated hole wall of FIGURE 1a at an X500 magnification.

FIGURE 2a is an X100 magnification SEM of a hole wall treated with concentrated $H_2SO_4$.

FIGURE 2b is the treated hole wall of FIGURE 2a at an X500 magnification.

FIGURE 3a is an X100 magnification SEM of a hole wall treated with concentrated $H_2SO_4$ containing 100 gm/liter of ammonium persulfate.

FIGURE 3b is the treated hole wall of FIGURE 3a at an X500 magnification.

FIGURE 4a is an X100 SEM of a hole wall treated with concentrated $H_2SO_4$, activated to electroless copper deposition, and electrolessly copper plated.

FIGURE 4b is the treated hole wall of FIGURE 4a at an X500 magnification.

FIGURE 5a is an X100 SEM of an untreated hole activated to electroless copper deposition and electrolessly copper plated.

FIGURE 5b is the untreated and plated hole wall of FIGURE 5a at an X500 magnification.

THERMOPLASTIC DIELECTRIC CORE MATERIAL

A. Polyarylates

The polyarylates which are suitable for use in this invention are derived from a dihydric phenol and at least one aromatic dicarboxylic acid and have a reduced viscosity of from about 0.4 to greater than about 1.0, preferably from about 0.6 to about 0.8 dl/gm, as measured in chloroform (0.5 g/100ml chloroform) or other suitable solvent at 25°C.

A suitable class of dihydric phenols has the following formula:

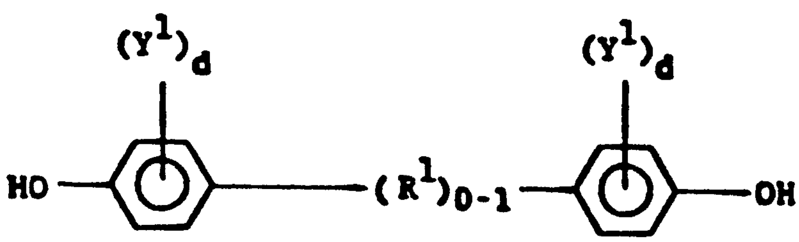

wherein $Y^1$ is independently selected from, hydrogen, alkyl groups of 1 to 4 carbon atoms, chlorine or bromine, each d, independently, has a value of from 0 to 4, inclusive, and $R^1$ is a divalent saturated or unraturated aliphatic hydrocarbon radical, particularly an alkylene or alkylidene radical having from 1 to 6 carbon atoms, or a cycloalkylidene or cycloakylene radicals having

up to and including 9 carbon atoms, O, CO, $SO_2$, or S. The dihydric phenols may be used individually or in combination.

Examples of useful dihydric phenols include the following:

2,2-bis-4(4-hydroxyphenyl)propane;
bis-(2-hydroxyphenyl)methane,
bis-(4-hydroxyphenyl)methane,
bis-(4-hydroxy-2,6-dimethyll-3-methoxyphenyl) methane,
1,1-bis-(4-hydroxyphenyl)ethane,
1,2-bis-(4-hydroxyphenyl) ethane,
1,1-bis-(4-hydrox-2-chlorophenyl)ethane,
1,3-bis-(3-methyl-4-hydroxyphenyl)ethane,
1,3-bis-(3-methyl-4-hydroxyphenyl)propane,
2,2-bis-(3-phenyl-4-hydroxyphenyl)propane,
2,2-bis-(3-isopropyl-4-hydroxyphenyl) propane,
2,2-bis-(2-isopropyl-4-hydroxyphenyl) propane,
2,2-bis-(4-hydroxyphenyl)pentane,
3,3-bis-(4-hydroxyphenyl)pentane,
2,2-bis-(4-hydroxyphenyl)heptane,
1,3-bis-(4-hydroxyphenyl)1,2-bis-(phenyl)-propane,
4,4'-(dihydroxyphenyl)ether,
4,4'-(dihydroxyphenyl)sulfide,
4,4'-(dihydroxyphenyl)sulfone,
4,4'-(dihydroxyphenyl)sulfoxide,
4,4'-(dihydroxybenzophenone), and
naphthalene diols

The aromatic dicarboxylic acids that may be used in this invention include terephthalic acid,

isophthalic acid, any of the naphthalene dicarboxylic acids and mixtures thereof, as well as alkyl substituted homologs of these carboxylic acids, wherein the alkyl group contains from 1 to about 4 carbon atoms, and acids containing other inert substituents, such as halides, alkyl or aryl ethers, and the like. Acetoxybenzoic acid can also be used. Preferably, mixtures of isophthalic and terephthalic acids are used. The isophthalic acid to terephthalic acid ratio in the mixture is about 0:100 to about 100:0, while the most preferred acid ratio is about 75:25 to about 50:50. Also, from about 0.5 to about 20 percent of aliphatic diacids containing from 2 to about 10 carbon atoms, such as adipic acid, sebacic acid, and the like may be additionally used in the polymerization reaction.

The polyarylates of the present invention can be prepared by any of the well known prior art polyester forming reactions, such as the reaction of the acid chlorides of the aromatic dicarboxylic acids with the dihydric phenols; the reaction of the diaryl esters of the aromatic dicarboxylic acids with the dihydric phenols; or the reaction of the aromatic diacids with diester derivatives of the dihydric phenol. These processes are described in, for example, U.S. Patents 3,317,464; 3,948,856; 3,780,148; 3,824,213; and 3,133,898.

B. Polyetherimides

The thermoplastic polyetherimide. suitable for use in this invention are well known in the art and are described in, for example, U.S. Patents 3,847,867, 3,838,097 and 4,107,147.

A preferred class of polyetherimides has the following formula:

(I) 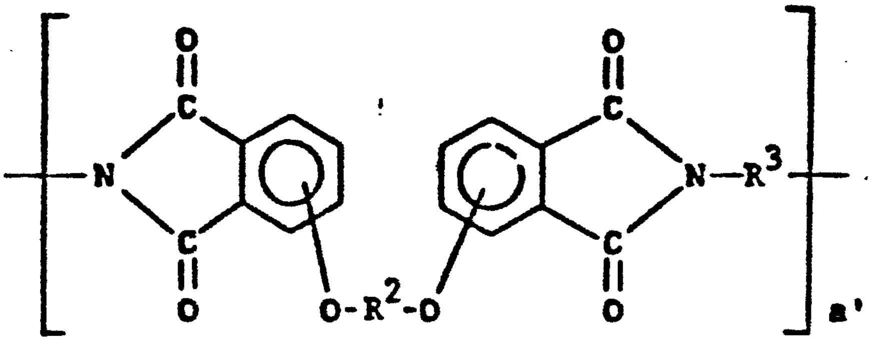

wherein a' is an integer greater than 1, preferably from about 10 to about 10,000 or more, and $-O-R^2-O-$ is attached to the 3 or 4 and 3' or 4' positions. $R^2$ is selected from (a) a substituted or unsubstituted aromatic radical such as

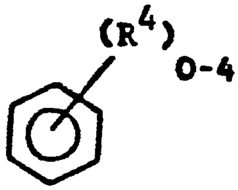

, or

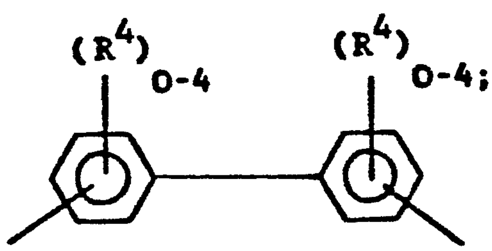

(b) a divalent radical of the formula:

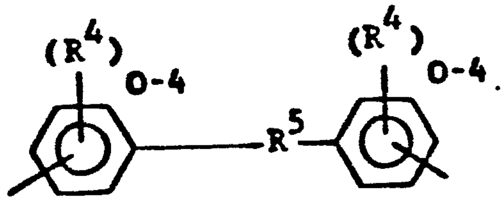

wherein $R^4$ is independently $C_1$ to $C_6$ alkyl, aryl or halogen and

$R^5$ is selected from -O-, -S-, $-\overset{O}{\overset{\|}{C}}-$, $-SO_2-$, -SO-, alkylene of 1 to 6 carbon atoms, cycloalkylene of 4 to 8 carbon atoms, alkylidene of 1 to 6 carbon atoms or cycloalkylidene of 4 to 8 carbon atoms. $R^3$ is selected from an aromatic hydrocarbon radical having from 6 to 20 carbon atoms and halogenated derivatives thereof, or alkyl substituted derivatives thereof, wherein the alkyl group contains 1 to 6 carbon atoms, alkylene and cycloalkylene radicals having from 2 to 20 carbon atoms and $C_2$ to $C_8$ alkylene terminated polydiorganosiloxane or a divalent radical of the formula

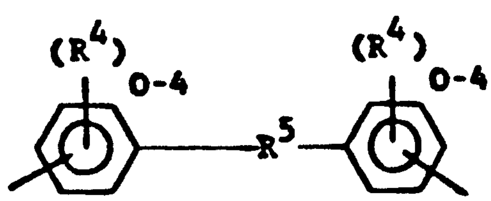

wherein $R^4$ and $R^5$ are as previously defined.

The polyetherimides may also be of the following formula:

(II) 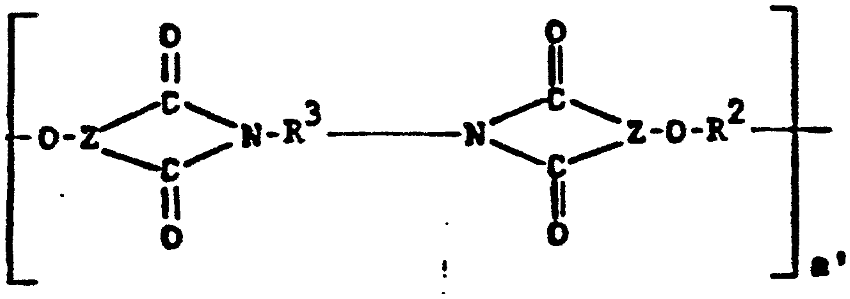

wherein -O-Z is a member selected from

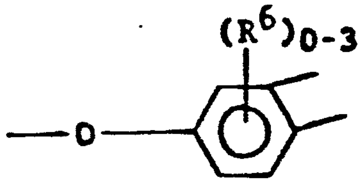

wherein $R^6$ is independently hydrogen, lower alkyl or lower alkoxy

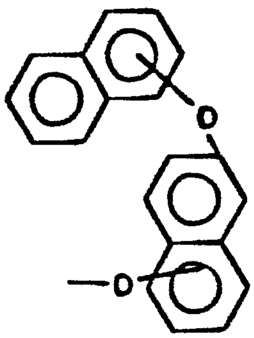

and,

wherein the oxygen may be attached to either ring and located ortho or para to one of the bonds of the imide carbonyl groups, $R^2$ and $R^3$ and a' are as previously defined.

These polyetherimides are prepared by methods well known in the art as set forth in, for example, U.S. Patents 3,833,544, 3,887,588, 4,017,511, 3,965,125 and 4,024,110.

The polyetherimides of Formula (I) can, for example, be obtained by any of the methods

well-known to those skilled in the art including the reaction of any aromatic bis(ether anhydride)s of the formula

(III) 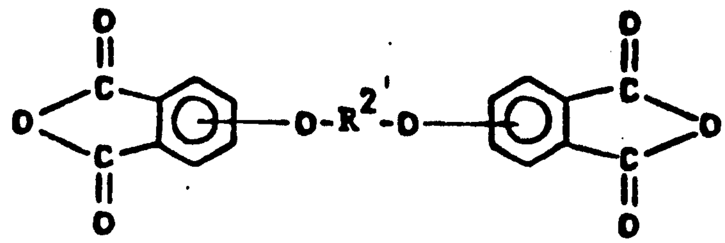

where $R^2$ is as defined hereinbefore, with a diamino compound of the formula

(IV) $H_2N-R^3-NH_2$

where $R^3$ is as defined hereinbefore. In general, the reactions can be advantageously carried out employing well-known solvents, e.g., o-dichlorobenzene, m-cresol/toluene, N,N-dimethylacetamide, etc., in which to effect interaction between the dianhydrides and diamines, at temperatures of from about 20 to about 250°C. Alternatively, the polyetherimides can be prepared by melt polymerization of any dianhydrides of Formula III with any diamino compound of Formula IV while heating the mixture of the ingredients at elevated temperatures with concurrent intermixing. Generally, melt polymerization temperatures between about 200° to 400°C and preferably 230° to 300°C can be employed. Any order of addition of chain stoppers ordinarily employed in melt polymerizations can be employed. The conditions of the reaction and the proportions of ingredients can be varied widely depending on the desired molecular weight, intrinsic

0216513

viscosity, and solvent resistance. In general, equimolar amounts of diamine and dianhydride are employed for high molecular weight polyetherimides, however, in certain instances, a slight molar excess (about 1 to 5 mole percent) of diamine can be employed resulting in the production of polyetherimides of Formula I have an intrinsic viscosity [η] greater than 0.2 deciliters per gram, preferably 0.35 to 0.60, or 0.7 deciliters per gram or even higher when measured in m-cresol at 25°C.

The aromatic bis(ether anhydride)s of Formula III include, for example,

2,2-bis[4-(2,3-dicarboxyphenoxy)phenyl]-propane dianhydride;

4,4'-bis(2,3-dicarboxyphenoxy)diphenyl ether dianhydride;

1,3-bis(2,3-dicarboxyphenoxy)benzene dianhydride;

4,4'-bis(2,3-dicarboxyphenoxy)diphenyl sulfide dianhydride;

1,4-bis(2,3-dicarboxyphenoxy)benzene dianhydride;

4,4'-bis(2,3-dicarboxyphenoxy)benzophenone dianhydride;

4,4'-bis(2,3-dicarboxyphenoxy)diphenyl sulfone dianhydride;

2,2-bis[4-(3,4-dicarboxyphenoxy)phenyl]-propane dianhydride;

4,4'-bis(3,4-dicarboxyphenoxy)diphenyl ether dianhydride;

4,4'-bis(3,4-dicarboxyphenoxy)diphenyl sulfide dianhydride;

1,3-bis(3,4-dicarboxyphenoxy)benzene dianhydride;

1,4-bis(3,4-dicarboxyphenoxy)benzene dianhydride;

4,4'-bis(3,4-dicarboxyphenoxy)benzophenone dianhydride;

4-(2,3-dicarboxyphenoxy)-4'-(3,4-dicarboxyphenoxy)diphenyl-2,2-propane dianhydride; etc. and mixures of such dianhydrides.

The organic diamines of Formula IV include, for example, m-phenylenediamine, p-phenylenediamine, 2,2-bis(p-aminophenyl)propane, 4,4'-diaminodiphenylmethane, 4,4'-diaminodiphenyl sulfide, 4,4'-diaminodiphenyl sulfone, 4,4'-diaminodiphenyl ether, 1,5-diaminonaphthalene, 3,3'-dimethylbenzidine, 3,3'-dimethoxybenzidine,

The polyetherimides of formula (II) may, for example, be prepared by effecting reaction in the presence of a dipolar aprotic solvent of a mixture of ingredients comprising, for instance, (1) a bis(nitrophthalimide) of the general formula:

(V) 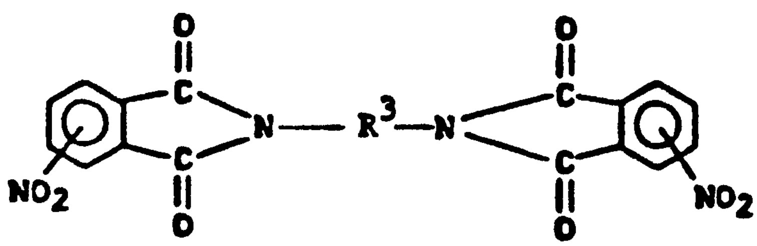

wherein $R^3$ is defined as hereinabove, and (2) an alkali metal salt of an organic compound of the general formula:

(VI) $$MO-R^2-OM$$

wherein M is an alkali metal and $R^2$ is defined as hereinabove.

The bis(nitrophthalimide) used in preparing the polymer is formed by reacting a diamine of the formula described above, $NH_2$-$R^3$-$NH_2$, with a nitro-substituted aromatic anhydride of the formula:

(VII)

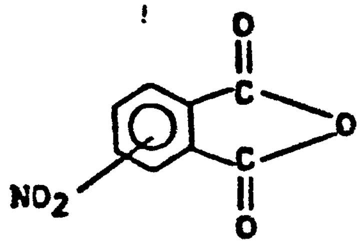

The molar ratio of diamine to anhydride should ideally be about 1:2 respectively. The initial reaction product is a bis(amide-acid) which is subsequently dehydrated to the corresponding bis(nitrophthalimide).

The diamines are described, <u>supra</u>.

The preferred nitrophthalic anhydrides useful in the present invention are 3-nitrophthalic anhydride, 4-nitrophthalic anhydride and mixtures thereof. These reactants are commercially available in reagent grade. They may also be prepared by the nitration of phthalic anhydride using procedures described in Organic Syntheses, Collective Vol. I, Wiley (1948), page 408. Certain other closely related nitroaromatic anhydrides may also be used in the reaction and are illustrated for example by 2-nitronaphthalic anhydride, 1-nitro-2,3-naphthalene-dicarboxylic anhydride and 3-methoxy-6-nitrophthalic anhydride, and the like.

With reference to the alkali metal salts of formula VI among the divalent carbocyclic aromatic radicals which $R^2$ may represent (mixtures of such radicals are also included) are, for instance,

divalent aromatic hydrocarbon radicals of from 6 to 20 carbon atoms, such as phenylene, biphenylene, naphthylene, etc. Included are residues of, e.g., hydroquinone, resorcinol, chlorohydroquinone, etc. In addition, $R^2$ may be a residue of a dihydroxy diarylene compound in which the aryl nuclei are joined by either an aliphatic group, a sulfoxide group, sulfonyl group, sulfur, carbonyl group, oxygen, etc. Typical of such diarylene compounds are the following:

2,4-dihydroxydiphenylmethane;
bis(2-hydroxyphenyl)methane;
2,2-bis(4-hydroxyphenyl)propane;
bis(4-hydroxyphenyl)methane;
bis(4-hydroxy-5-nitrophenyl)methane;
bis(4-hydroxy-2,6-dimethyl-3-methoxyphenyl)methane;
1,1-bis(4-hydroxyphenyl)ethane;
1,2-bis(4-hydroxyphenyl)ethane;
1,1-bis(4-hydroxy-2-chlorophenyl)ethane;
1,1-bis(2,5-dimethyl-4-hydroxyphenyl)ethane;
1,3-bis(3-methyl-4-hydroxyphenyl)propane;
2,2-bis(3-phenyl-4-hydroxyphenyl)propane;
2,2-bis(3-isopropyl-4-hydroxyphenyl)propane;
2,2-bis(4-hydroxynaphthyl)propane;
hydroquinine;
naphthalene diols;
bis(4-hydroxyphenyl)ether;
bis(4-hydroxyphenyl)sulfide;
bis(4-hydroxyphenyl)sulfone; and the like.

When dialkali metal salts of formula VI are used with the compound illustrated by formula V, the

ingredients are advantageously present in an equal molar ratio for optimum molecular weight and properties of the polymer. Slight molar excesses, e.g., about 0.001 to 0.10 molar excess of either the dinitro-substituted organic compound or of the dialkali metal salt of formula (VI) may be employed. When the molar ratios are approximately equal, the polymer is substantially terminated by a = $Z-NO_2$ at one end and a phenolic group at the other end. If there is a molar excess of one compound, that particular terminal group will predominate.

The conditions of reaction whereby the alkali-metal salt of formula VI is reacted with the dinitro-substituted organic compound of formula V can be varied widely. Generally, temperatures of the order of about 25 to about 150°C are advantageously employed, although it is possible to employ lower or higher temperature conditions depending on the ingredients used, the reaction product sought, time of reaction, solvent employed, etc. In addition to atmospheric pressure, superatmospheric pressures and subatmospheric pressures may be employed depending upon the other conditions of reaction, the ingredients used, the speed at which it is desired to effect reaction, etc.

The time of reaction also can be varied widely depending on the ingredients used, the temperature, the desired yield, etc. It has been found that times varying from about 5 minutes to as much as 30 to 40 hours are advantageously employed to obtain the maximum yield and desired molecular

weight. Thereafter the reaction product can be treated in the appropriate manner required to effect precipitation and/or separation of the desired polymeric reaction product. Generally, common solvents such as alcohols (e.g., methanol, ethanol, isopropyl alcohol, etc.) and aliphatic hydrocarbons (e.g., pentane, hexane, octane, cyclohexane, etc.) may be employed as precipitants for this purpose.

It is important that the reaction between the dinitro-substituted organic compound of formula V and the alkali-metal salt of formula VI (mixtures of such alkali-metal salts can also be used) be carried out in the presence of a dipolar aprotic solvent.

The polymerization is performed under anhydrous conditions usually using dipolar aprotic solvents such as dimethylsulfoxide which are added in varying amounts depending upon the particular polymerization. A total quantity of solvent, dipolar aprotic solvent or mixture of such solvent with an aromatic solvent sufficient to give a final solution containing 10 to 20% by weight of polymer is preferably employed.

Useful polyetherimides include those having repeating units of the following formula:

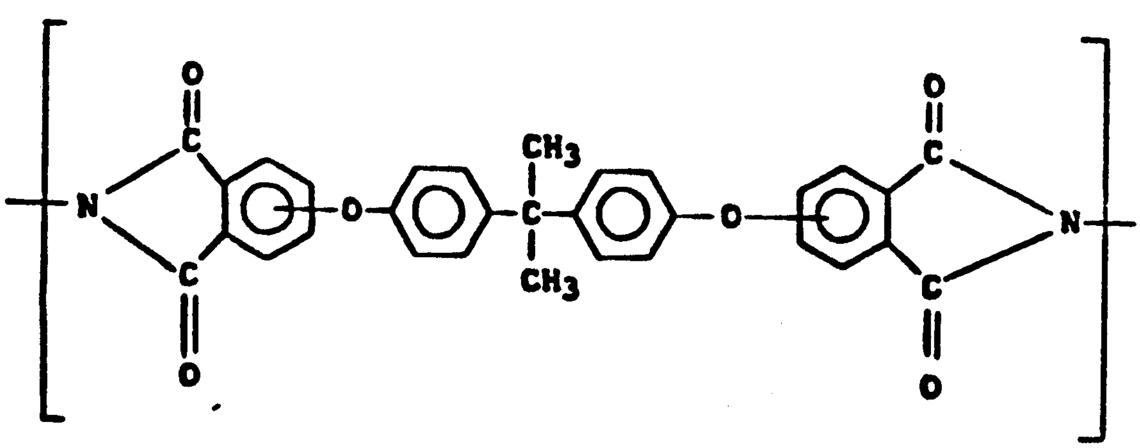

C. Polyesters

The polyesters which are suitable for use herein are derived from an aliphatic or cyloaliphatic diol, or mixtures thereof, containing from 2 to about 10 carbon atoms and at least one aromatic dicarboxylic acid. The polyesters which are derived from an aliphatic diol and an aromatic dicarboxylic acid have repeating units of the following general formula:

(VIII) 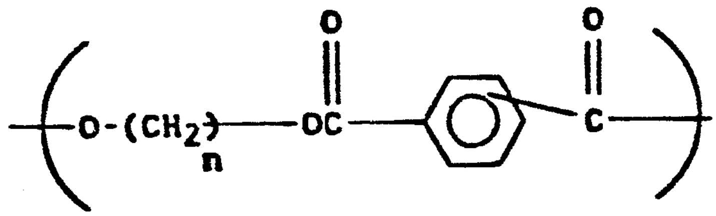

wherein n is an integer of from 2 to 10.

Also contemplated herein are the above polyesters with minor amounts, e.g., from 0.5 to about 2 percent by weight, of units derived from aliphatic acids and/or aliphatic polyols, to form copolyesters. The aliphatic polyols include glycols, such as poly(ethylene glycol). These can be made following the teachings of, for example, U.S. Patents 2,465,319 and 3,047,539.

The polyesters which are derived from a cycloaliphatic diol and an aromatic dicarboxylic acid are prepared by condensing either the cis - or trans-isomer (or mixtures thereof) of, for example, 1,4-cyclohexanedimethanol with an aromatic dicarboxylic acid so as to produce a polyester having recurring units of the following formula:

(IX) 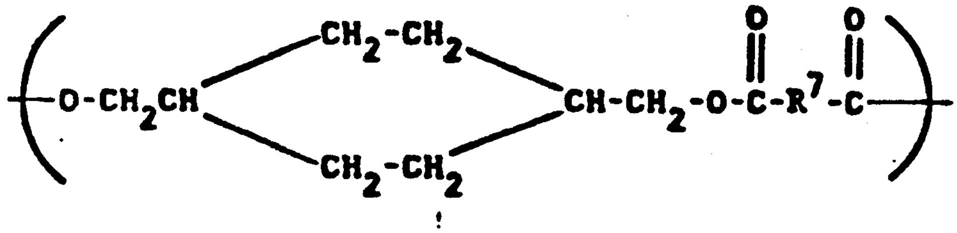

wherein the cyclohexane ring is selected from the cis- and trans- isomers thereof and $R^7$ represents an aryl radical containing 6 to 20 carbon atoms and which is the decarboxylated residue derived from an aromatic dicarboxylic acid.

Examples of aromatic dicarboxylic acids indicated by $R^7$ in formula IX, are isophthalic or terephthalic acid, 1,2-di(p-carboxyphenyl)ethane, 4,4'-dicarboxydiphenyl ether, etc., and mixtures of these. All of these acids contain at least one aromatic nucleus. Fused rings can also be present, such as in 1,4-or 1,5-naphthalenedicarboxylic acids. The preferred dicarboxylic acids are terephthalic acid or a mixture of terephthalic and isophthalic acids.

The polyesters as described herein are either commercially available or can be produced by methods well known in the art, such as those set forth in, for example, U.S. Patent 2,901,466.

The polyesters used herein have an intrinsic viscosity of from about 0.4 to about 2.0 dl/g. as measured in a 60:40 phenol/tetrachloroethane mixture or similar solvent at 23 to 30°C.

D. Aromatic Polycarbonate

The thermoplastic aromatic polycarbonates that can be employed herein are homopolymers and

copolymers and mixtures thereof, which have an intrinsic viscosity of from about 0.4 to about 1.0 dl./g. as measure in methylene chloride at 25°C. The polycarbonates are prepared by reacting a dihydric phenol with a carbonate precursor. Typical of some of the dihydric phenols that may be employed are bisphenol-A, bis(4-hydroxyphenyl)methane, 2,2-bis(4-hydroxy-3-methylphenyl)propane, 4,4-bis(4-hydroxyphenyl)heptane, 2-2-(3,5,3',5'tetrabromo-4,4'-dihydroxydiphenyl)propane, (3,3'dichloro-4,4'dihydroxydiphenyl)methane, and the like. Other dihydric phenols of the bisphenol type are described in, for example, U.S. Patents, 2,999,835, 3,028,365 and 3,334,154.

It is, of course, possible to employ two or more different dihydric phenols or a copolymer of a dihydric phenol with a glycol or with hydroxy or acid terminated polyesters.

The carbonate precursor may be either a carbonyl halide, a carbonate ester, or a haloformate. The carbonyl halides which can be employed herein are carbonyl bromide, carbonyl chloride and mixtures thereof. Typical of the carbonate esters which may be employed herein are diphenyl carbonate, di-(halophenyl)carbonates, such as di-(chlorophenyl)carbonate or di-(bromophenyl)carbonate, etc., di-(alkylphenyl)carbonates such as di(tolyl)carbonate, di(naphthyl)carbonate, di(chloronaphthyl)carbonate, etc. or mixtures thereof. The haloformates suitable for use herein include bis-haloformate of dihydric phenols for

example, bischloroformates of bisphenol-A, of hydroquinone, etc. or glycols for example, bishaloformates of ethylene glycol, neopentyl glycol, polyethylene glycol, etc. While other carbonate precursors will be apparent to those skilled in the art, carbonyl chloride, also known as phosgene, is preferred.

The aromatic polycarbonate polymers may be prepared by methods well known in the art by using phosgene or a haloformate and by employing a molecular weight regulator, an acid acceptor and a catalyst. The molecular weight regulators which can be employed in carrying out the process include monohydric phenols, such as phenol, para-tertiary-butylphenol, para-bromophenol, primary and secondary amines, etc. Preferably, a phenol is employed as the molecular weight regulator.

A suitable acid acceptor may be either an organic or an inorganic acid acceptor. A suitable organic acid acceptor is a tertiary amine and includes materials, such as pyridine, triethylamine, dimethylaniline, tributylamine, etc. The inorganic acid acceptor may be one which can be either a hydroxide, a carbonate, a bicarbonate, or a phosphate of an alkali or alkaline earth metal.

The catalysts which are employed herein can be any of the suitable catalysts that aid the polymerization of, for example, bisphenol-A with phosgene. Suitable catalysts include tertiary amines, such as triethylamine, tripropylamine, N,N-dimethylaniline, quaternary ammonium compounds, such as tetraethylammonium bromide, cetyl triethyl

ammonium bromide, tetra-n-heptylammonium iodide, and quaternary phosphonium compounds, such as n-butyltriphenyl-phosphonium bromide and methyl-triphenyl phosphonium bromide.

The polycarbonates can be prepared in a one-phase (homogeneous solution) or a two-phase (interfacial) systems when phosgene, or a haloformate are used. Bulk reactions are possible when the diarylcarbonate precursors are used.

Also, aromatic polyester carbonates may be used. These are described in, for example, U.S. Patent 3,169,121. A useful polyester carbonate results, for example, from the condensation of phosgene, terephthaloyl chloride, isophthaloyl chloride with bisphenol-A and a small amount of p-tertbutylphenol.

E. Poly(aryl ether)

The poly(aryl ether) polymer may be described as a linear, thermoplastic polyarylene polyether wherein the arylene units are interspersed with other ether, sulfone or ketone linkages. These polymers may be obtained by reaction of an alkali metal double salt of a dihydric phenol and a dihalobenzenoid or dinitrobenzenoid compound, either or both of which contain a sulfone or a ketone linkage, i.e., $-SO_2-$ or -CO-, between arylene groupings, to provide sulfone or ketone units in the polymer chain in addition to arylene units and ether units. The polymer has a basic structure comprising recurring units of the formula:

$$O-E-O-E'$$

wherein E is the residuum of the dihydric phenol and E' is the residuum of the benzenoid compound having an inert electron withdrawing group in at least one of the positions ortho and para to the valence bonds; both of said residua are valently bonded to the ether oxygens through aromatic carbon atoms. Such aromatic polyethers are included within the class of polyarylene polyester resins described in, for example, U.S. Patents 3,264,536 and 4,175,175. It is preferred that the dihydric phenol be a weakly acidic dinuclear phenol such as, for example, the dihydroxyl diphenyl alkanes or the nuclear halogenated derivatives thereof, such as, for example, 2,2-bis(4-hydroxyphenyl)propane, 1,1-bis(4-hydroxyphenyl)2-phenyl ethane, bis(4-hydroxyphenyl)methane, or their chlorinated derivatives containing one or two chlorines on each aromatic ring. Other materials also termed appropriately "bisphenols" are also highly valuable and preferred. These materials are the bisphenols of a symmetrical or unsymmetrical joining group, as, for example, ether oxygen (-O-), carbonyl $(-\overset{O}{\overset{\|}{C}}-)$, sulfone $(-\underset{\underset{O}{\|}}{\overset{\overset{O}{\|}}{S}}-)$, or hydrocarbon residue in which the two phenolic nuclei are joined to the same or different carbon atoms of the residue.

Such dinuclear phenols can be characterized as having the structure:

$$\begin{array}{c} (A_1)_f \quad\quad (A_2)_g \\ | \quad\quad\quad\quad / \\ HO(Ar-R^8 - Ar)OH \end{array}$$

wherein Ar is an aromatic group and preferably is a phenylene group, $A_1$ and $A_2$ can be the same or different inert substituent groups such as alkyl groups having from 1 to 4 carbons atoms, halogen atoms, i.e., fluorine, chlorine, bromine or iodine, or alkoxyl radicals having from 1 to 4 carbon atoms, f and g are integers having a value from 0 to 4, inclusive, and $R^8$ is representative of a bond between aromatic carbon atoms as in dihydroxyl-diphenyl, or is a divalent radical, including for example, radicals such as $-\overset{O}{\overset{\|}{C}}-$, -O-, -S-, -SO-, -S-S-, $-SO_2$, and divalent hydrocarbon radicals such as alkylene, alkylidene, cycloalkylene, cycloalkylidene, or the halogen, alkyl, aryl or like substituted alkylene, alkylidene and cycloaliphatic radicals as well as aromatic radicals and rings fused to both Ar groups.

Examples of specific dihydric polynuclear phenols including among others: the bis-(hydroxyphenyl) alkanes such as
2,2-bis-(4-hydroxyphenyl)propane,
2,4'-dihydroxydiphenylmethane,
bis-(2-hydroxyphenyl)methane,
bis-(4-hydroxyphenyl)methane,
bis(4-hydroxy-?,6-dimethyl-3-methoxyphenyl)methane,
1,1-bis-(4-hydroxyphenyl)ethane,
1,2-bis-(4-hydroxyphenyl)ethane,
1,1-bis-(4-hydroxy-2-chlorophenyl)ethane,

1,1-bis-(3-methyl-4-hydroxyphenyl)propane,
1,3-bis-(3-methyl-4-hydroxyphenyl)propane,
2,2-bis-(3-phenyl-4-hydroxyphenyl)propane,
2,2-bis-(3-isopropyl-4-hydroxyphenyl)propane,
2,2-bis-(2-isopropyl-4-hydroxyphenyl)propane,
2,2-bis-(4-hydroxy-naphthyl)-propane,
2,2-bis-(4-hydroxyphenyl)pentane,
3,3-bis-(4-hydroxyphenyl)pentane,
2,2-bis-(4-hydroxyphenyl)heptane,
bis-(4-hydroxyphenyl)phenylmethane,
2,2-bis-(4-hydroxyphenyl)-1-phenyl-propane,
2,2-bis-(4-hydroxyphenyl)1,1,1,3,3,3,-hexafluoropropane, and the like;

di(hydroxyphenyl)sulfones such as
bis-(4-hydroxy-phenylsulfone),
2,4'-dihydroxydiphenyl sulfone,
5-chloro-2,4'-dihydroxydiphenyl sulfone,
5'-chloro-4,4'-dihydroxydiphenyl sulfone, and the like;

di(hydroxyphenyl) ethers such as
bis-(4-hydroxyphenyl)ether, the 4,3'-,
4,2'-2,2'-2,3-,dihydroxyphenyl ethers,
4,4'-dihydroxy-2,6-dimethyldiphenyl
ether,bis-(4-hydroxy-3-isobutylphenyl) ether,
bis-(4-hydroxy-3-isopropylphenyl) ether,
bis-(4-hydroxy-3-chlorophenyl) ether,
bis-(4-hydroxy-3-fluorophenyl) ether,
bis-(4-hydroxy-3-bromophenyl) ether,
bis-(4-hydroxynaphthyl) ether,
bis-(4-hydroxy-3-chloronaphthyl) ether, and
4,4'-dihydroxy-3,6-dimethoxydiphenyl ether.

Also preferred as useful dihydric phenols are the following:

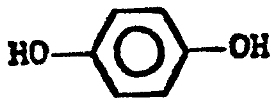 , and

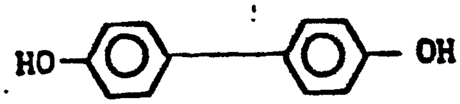

As herein used the E term defined as being the "residuum of the dihydric phenol" of course refers to the residue of the dihydric phenol after the removal of the two aromatic hydroxyl groups. Thus as is readily seen these polyarylene polyethers contain recurring groups of the residuum of the dihydric phenol and the residuum of the benzenoid compound bonded through an aromatic ether oxygen atom.

Any dihalobenzenoid or dinitrobenzenoid compound or mixtures thereof can be employed in this invention to supply an E' residuum, which compound or compounds has the two halogens or nitro-groups bonded to benzene rings having an electron withdrawing group in at least one of the positions ortho and para to the halogen or nitro group. The dihalobenzenoid or dinitrobenzenoid compound can be either mononuclear
where the halogens or nitro groups are attached to the same benzenoid rings or polynuclear where they are attached to different benzenoid rings, as long as there is an activating electron withdrawing group

in the ortho or para position of that benzenoid nucleus. Fluorine and chlorine substituted benzenoid reactants are preferred; the fluorine compounds for fast reactivity and the chlorine compounds for their inexpensiveness. Fluorine substituted benzenoid compounds are most preferred, particularly when there is a trace of water present in the polymerization reaction system. However, this water content should be maintained below about 1% and preferably below 0.5% for best results.

Examples of benzenoid compounds which are useful in contributing E' residua to a poly(aryl ether) resin are the following:

4,4'-dichlorodiphenyl sulfone,
4,4'-difluorodiphenyl sulfone,
4,4'-bis(4-chlorophenylsulfonyl)biphenyl,
4,4'-bis(4-fluorophenylsulfonyl)biphenyl,
4,4'-difluorobenzophenone,
4,4'-dichlorobenzophenone,
4,4'-bis(4-fluorobenzoyl)benzene,
4,4'-bis(4-chlorobenzoyl)benzene,
2,6-dichlorobenzonitrile,

isomers thereof, and the like.

An electron withdrawing group can be employed as the activator group in these compounds. It should be, of course, inert under the reaction conditions, but otherwise its structure is not critical. Preferred are the strong activating groups such as the sulfone group $(-\underset{O}{\underset{\|}{\overset{O}{\overset{\|}{S}}}}-)$ bonding two halogen or nitro substituted benzenoid nuclei as in

the 4,4'-dichlorodiphenyl sulfone and 4,4'-difluorodiphenyl sulfone, although such other strong withdrawing groups hereinafter mentioned can also be used with equal ease.

The more powerful of the electron withdrawing groups give the fastest reactions and hence are preferred. It is further preferred that the ring contain no electron supplying groups on the same benzenoid nucleus as the halogen or nitro group; however, the presence of other groups on the nucleus or in the residuum of the compound can be tolerated. Preferably, all of the substituents on the benzenoid nucleus are either hydrogen (zero electron withdrawing), or other groups having a positive sigma* value, as set forth in J.F. Bunnett in Chem. Rev. 49 273 (1951) and Quart. Rev., 12, 1 (1958). See also Taft, Steric Effects in Organic Chemistry, John Wiley & Sons (1956), chapter 13; Chem. Rev., 53, 222; JACS, 74, 3120; and JACS, 75, 4231.

The activating group can be basically either of two types:

(a) monovalent groups that activate one or more halogens or nitro-groups on the same ring such as another nitro or halo group, phenylsulfone, or alkylsulfone, cyano, trifluoromethyl, nitroso, and hetero nitrogen, as in pyridine.

(b) divalent groups which can activate displacement of halogens on two different rings, such as the sulfone group 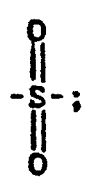; the carbonyl group

O                             H
||                            |
-C-; the vinylene group -C=C-; the sulfoxide group
                               |
                               H

O
||
-S-; the azo-group -N=N-; the saturated fluorocarbon groups $-CF_2CF_2-$; organic phosphine oxides

O
||
-P-:
||
$R^9$

where $R^9$ is a hydrocarbon group, and the ethylidene group $X^1$-C-$X^1$ where $X^1$ can be

||
-C-

hydrogen or halogen and activating groups within the nucleus which can activate halogens as nitro functions on the same ring such as in the case with difluorobenzoquinone, 1,4- or 1,5- or 1,8-difluoroanthroquinone, etc.

If desired, the polymers may be made with mixtures of two or more dihalobenzenoid or dinitrobenzenoid compounds. Thus, the E' residuum of the benzenoid compounds in the polymer structure may be the same or different.

It is seen also that as used herein, the E' term defined as being the "residuum of the benzenoid compound" refers to the aromatic or benzenoid residue of the compound after the removal of the halogen atom or nitro group on the benzenoid nucleus. The polyarylene polyethers of this invention are prepared by methods well known in the art as for instance the substantially equimolar one-step reaction of a double alkali metal salt of dihydric phenol with a dihalobenzenoid compound in

the presence of specific liquid organic sulfoxide or sulfone solvents under substantially anhydrous conditions. Catalysts are not necessary for this reaction.

The polymers may also be prepared in a two-step process in which a dihydric phenol is first converted *in situ* in the primary reaction solvent to the alkali metal salt of the reaction with the alkali metal, alkali metal hydride, alkali metal hydroxide, alkali metal alkoxide or the alkali metal alkyl compounds. Preferably, the alkali metal hydroxide is employed. After removing the water which is present or formed, in order to secure substantially anhydrous conditions, the dialkali metal salts of the dihydric phenol are admixed and reacted with about stoichiometric quantities of the dihalobenzenoid or dinitrobenzenoid compound.

The polymerization reaction proceeds in the liquid phase of a sulfoxide or sulfone organic solvent at elevated temperatures.

A preferred form of the poly(aryl ether) of this invention are those prepared using the dihydric polynuclear phenols of the following types, including the derivatives thereof which are substituted with inert substituent groups

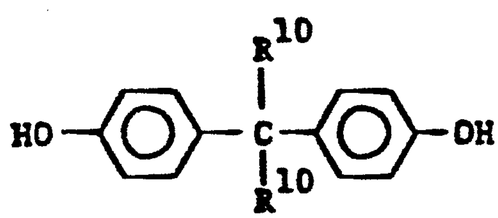

in which the $R^{10}$ group represents independently hydrogen, lower alkyl, aryl and the halogen

substituted groups thereof, which can be the same or different;

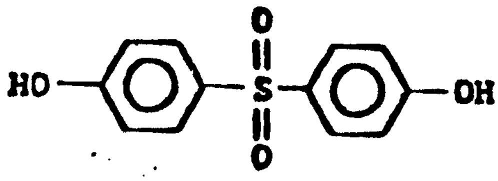

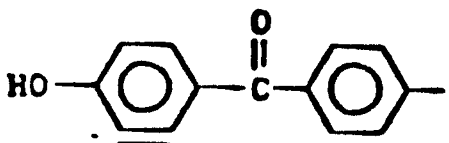, and

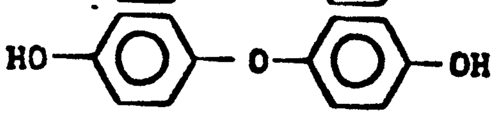

and substituted derivatives thereof.

It is also contemplated in this invention to use a mixture of two or more different dihydric phenols to accomplish the same ends as above. Thus when referred to above the -E- residuum in the polymer structure can actually be the same or different aromatic residua.

In order to secure the high polymers, the system should be substantially anhydrous, and preferably with less than 0.5 per cent by weight water in the reaction mixtures.

The poly(aryl ether)s have a reduced viscosity of from about 0.35 to about 1.5 as measured in an appropriate solvent at an appropriate temperature depending on the particular poly(aryl ether), such as in methylene chloride at 25°C.

The preferred poly(aryl ether)s have repeat units of the formula:

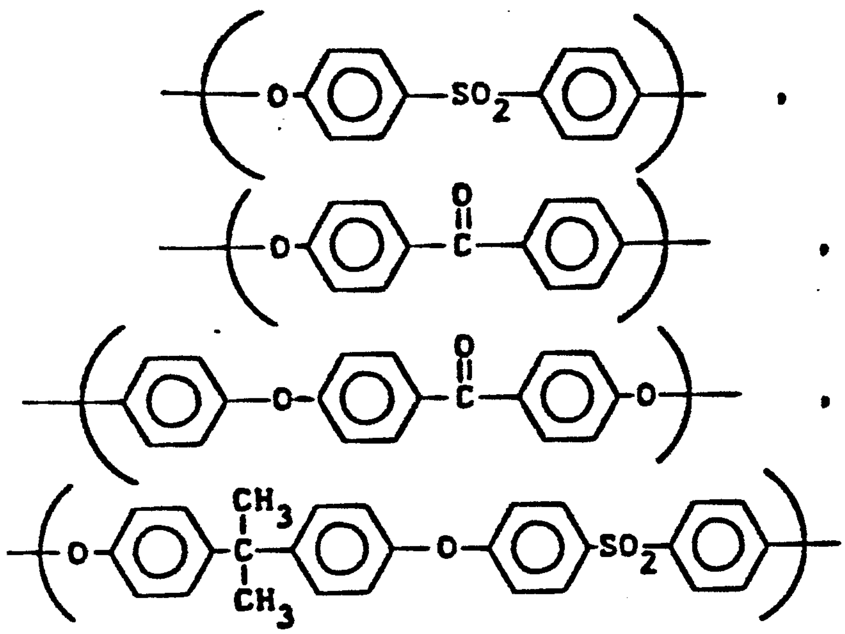

, , , and

F. Poly(aryl ether sulfones)

The poly(aryl ether sulfones) useful in this invention are amorphous thermoplastic polymers containing units of the formula:

(X) 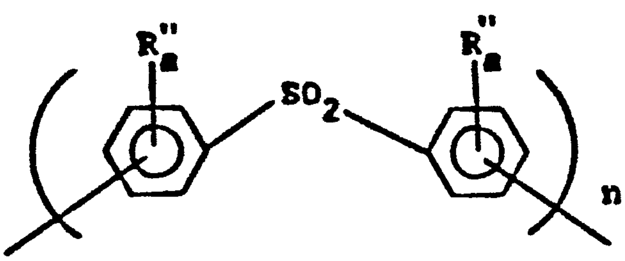 , and

(XI) 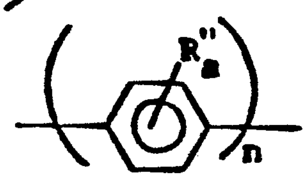

and/or

(XII) 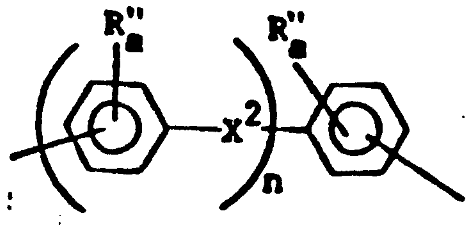

wherein R" is independently hydrogen, $C_1$ to $C_6$ alkyl or $C_4$ to $C_8$ cycloalkyl, $X^2$ is independently

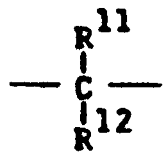

wherein $R^{11}$ and $R^{12}$ are independently hydrogen or $C_1$ to $C_9$ alkyl, or

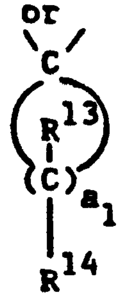

wherein $R^{13}$ and $R^{14}$ are independently hydrogen or $C_1$ to $C_8$ alkyl, and $a_1$ is an integer of 3 to

8; -S-, -O-, or 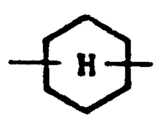 , a is an integer of 0 to 4

and n is independently an integer of 1 to 3 and wherein the ratio of unit (X) to the sum of units (XI) and/or (XII) is greater than 1. The units are attached to each other by an -O- bond.

A polymer useful in this invention contains units of the formula:

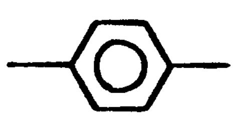

, and

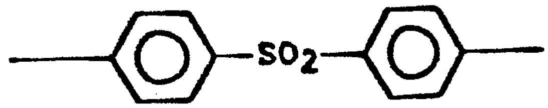

Another useful poly(aryl ether sulfone) contains units of the formula:

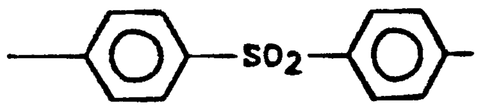 , and

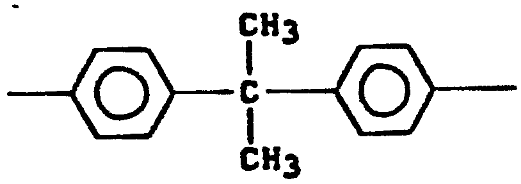

These units are attached to each other by an -O- bond.

The poly(aryl ether sulfone) may be random or may have an ordered structure.

The poly(aryl ether sulfones) have a reduced viscosity of from about 0.4 to greater than about 2.5, as measured in N-methylpyrolidone, or other suitable solvent, at 25°C.

The poly(aryl ether sulfones) useful in this invention are prepared by reacting the monomers represented by the following formulae:

(XIII) 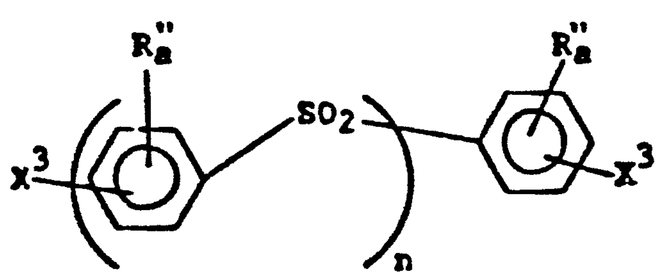

(XIV) 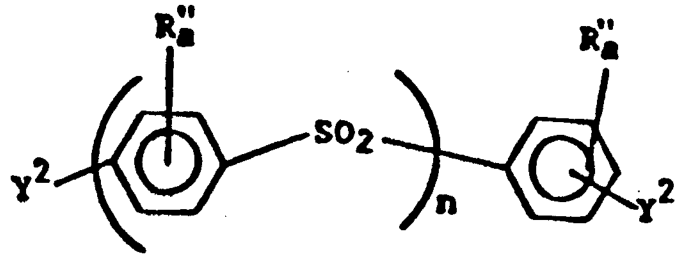

(XV) 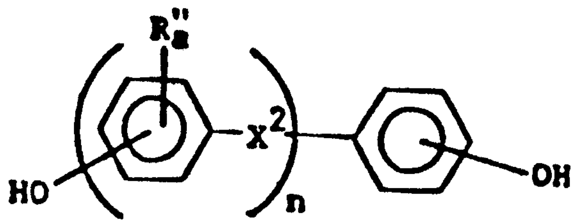

(XVI) and/or 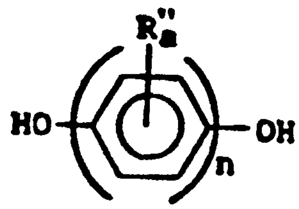

wherein R", a, $X^2$ and n are as previously defined, and $X^3$ and $Y^2$ are independently selected from Cl, Br, F, $NO_2$ or OH and at least 50 percent of the $Y^2$'s are OH.

The ratio of the concentration of OH groups to Cl, Br, F and/or $NO_2$ groups used to form the polyarylethersulfone is from about 0.90 to about 1.10, preferably from about 0.98 to about 1.02.

The monomers, represented by formulas (XIII), (XIV), (XV) and (XVI), include the following:

2,2-bis(4-hydroxyphenyl)propane,

bis(4-hydroxyphenyl)methane,

4,4'-dihydroxydiphenyl sulfide,

4,4'-dihydroxydiphenyl ether,

4,4'-dihydroxydiphenyl sulfone,
2,4'-dihydroxydiphenyl sulfone,
4,4'-dichlorodiphenyl sulfone,
4,4'-dinitrodiphenyl sulfone,
4-chloro-4'-hydroxydiphenyl sulfone,
4,4'-biphenol, hydroquinone, and the like.

The preferred monomers include hydroquinone, 4,4-biphenol, 2,2-bis(4-hydroxyphenyl) propane, 4,4'-dichlorodiphenyl sulfone, and 4,4'-dihydroxydiphenyl sulfone or 4 chloro -4'-hydroxydiphenyl sulfone.

The polymers may be prepared by contacting substantially equimolar amounts of the hydroxy containing compounds (depicted in formulas (XIII) to (XVI) supra) and halo and/or nitro containing compounds (depicted in formula (XIII) and (XIV) supra) with from about 0.5 to about 1.0 mole of an alkali metal carbonate per mole of hydroxyl group in a solvent mixture comprising a solvent which forms an azeotrope with water in order to maintain the reaction medium at substantially anhydrous conditions during the polymerization.

The temperature of the reaction mixture is kept at from about 120 to about 180°C, for about 1 to about 5 hours and then raised and kept at from about 200 to about 250°C, preferably from about 210 to about 230°C, for about 1 to 10 hours.

The reaction is carried out in an inert atmosphere, e.g., nitrogen, at atmospheric pressure, although higher or lower pressures may also be used.

The poly(aryl ether sulfone) is then recovered by conventional techniques such as coagulation, solvent evaporation, and the like.

The solvent mixture comprises a solvent which forms an azeotrope with water and a polar aprotic solvent. The solvent which forms an azeotrope with water includes an aromatic hydrocarbon such as benzene, toluene, xylene, ethylbenzene, chlorobenzene, and the like.

The polar aprotic solvents employed in this invention are those generally known in the art for the manufacture of poly(aryl ether sulfones) and include sulfur containing solvents such as those of the formula:

$$R^{15}-S(O)_b-R^{15}$$

in which each $R^{15}$ represents a monovalent lower hydrocarbon group free of aliphatic unsaturation, which preferably contains less than about 8 carbon atoms or when connected together represents a divalent alkylene group with b being an integer from 1 to 2 inclusive. Thus, in all of these solvents all oxygens and two carbon atoms are bonded to the sulfur atom. Contemplated as useful solvents are such solvents as those having the formula:

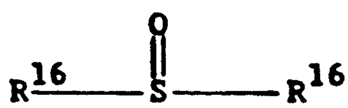 and 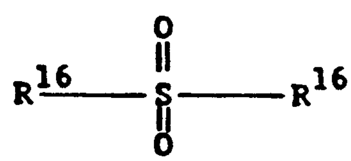

where the $R^{16}$ groups are independently lower alkyl, such as methyl, ethyl, propyl, butyl, and like groups, and aryl groups such as phenyl and alkylphenyl groups such as the tolyl group, as well as those where the $R^{16}$ groups are interconnected as in a divalent alkylene bridge such as:

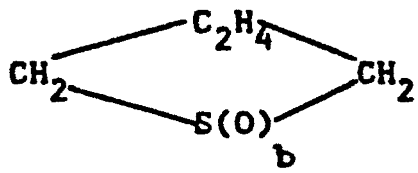

in tetrahydrothiophene oxides and dioxides. Specifically, these solvents include dimethylsulfoxide, dimethylsulfone, diphenylsulfone, diethylsulfoxide, diethylsulfone, diisopropylsulfone, tetrahydrothiophene 1,1-dioxide (commonly called tetramethylene sulfone or sulfolane) and tetrahydrothiophene-1 monoxide.

Additionally, nitrogen containing solvents may be used. These include dimethyl acetamide, dimethyl formamide and N-methylpyrolidone.

The azeotrope forming solvent and polar aprotic solvent are used in a weight ratio of from about 10:1 to about 1:1, preferably from about 7:1 to about 5:1.

In the reaction, the hydroxy containing compound is slowly converted, in situ, to the alkali salt thereof by reacting with the alkali metal carbonate. The alkali metal carbonate is preferably potassium carbonate. Mixtures of carbonates such as potassium and sodium carbonate may also be used.

Water is continuously removed from the reaction mass as an azeotrope with the azeotrope forming solvent so that substantially anhydrous conditions are maintained during the polymerization.

It is essential that the reaction medium be maintained substantially anhydrous during the polycondensation. While amounts of water up to about one percent can be tolerated, and are somewhat

beneficial when employed with fluorinated dihalobenzenoid compounds, amounts of water substantially greater than this are desirably avoided as the reaction of water with the halo and/or nitro compound leads to formation of phenolic species and only low molecular weight products are secured. Consequently, in order to secure the high polymers, the system should be substantially anhydrous, and preferably contain less than 0.5 percent by weight water during the reaction.

Preferably, after the desired molecular weight has been attained, the polymer is treated with an activated aromatic halide or an aliphatic halide such as methyl chloride or benzyl chloride, and the like. Such treatment of the polymer converts the terminal hydroxyl groups into ether groups which stabilize the polymer. The polymer so treated has good melt and oxidative stability.

## EXAMPLES

### Example 1

A sample of copper clad polysulfone circuit board (available from PCK Technology Division of Kollmorgen Corp. under the registered trademark TEKCLAD 1700) was drilled employing standard carbide PWB bits and using the following parameters:

1.) Stack 2
2.) Double hit
3.) Aluminum entry foil having a thickness of 12 to 16 mils.
4.) Masonite backup
5.) Feed 100 in./min.
6.) Spindle Speed 20,000 rpm

7.) Drill size #28 (1.1405 in. diameter)

FIGURE 1a is a scanning electron micrograph (SEM) taken at a magnification of X100 of a hole wall as drilled through the copper clad board. FIGURE 1b is an SEM of the same hole but at a higher magnification of X500.

The SEMs clearly display the hole wall surface and show the disadvantageous topography generated by the act of drilling. In particular, the SEMs show an abundance of feathery polysulfone fragments loosely attached to the hole wall. The presence of such feathery debris creates a poor surface for the adhesion of electroless metal plating such that voiding and hole wall pullaway would be expected.

Example 2

A sample of copper clad polysulfone circuit board (TEKCLAD® 1700) was drilled as in Example 1. The drilled sample was racked and treated in 96% $H_2SO_4$ with agitation for 2 minutes at 40° C. The board was then de-racked and rinsed in running water for 1 minute at room temperature (approx. 23°C). SEMs were then made of the hole wall surface in the board thus treated at X100 (FIG. 2a) and at X500 (FIG. 2b).

Relative to Example 1, FIGURES 2a and 2b show dramatic topographical changes on the hole wall surface. The SEMs show a marked reduction of loosely adherent debris and the onset of microcrazing of the hole wall. As previously noted, microcrazing has a beneficial effect upon electroless metal adhesion through increasing hole

wall surface area, reducing the wetting angle, and providing sites for mechanically anchoring the electroless metal deposit.

Example 3

A sample of copper clad polysulfone circuit board (TEKCLAD® 1700) was drilled as in Example 1. The drilled board was then racked and treated in 96% $H_2SO_4$ in which 100 gm./liter of ammonium persulfate had been dissolved. The $H_2SO_4$/persulfate solution was agitated during the treatment which was conducted for 3 minutes at 30°C. The board was then de-racked and rinsed in running water for 1 minute at room temperature. SEMs were then made of the hole wall surface at X100 (FIG. 3a) and at X500 (FIG. 3b).

FIGS. 3a and 3b depict the topographical enhancement obtained in the hole wall surface when an oxidizing agent such as ammonium persulfate is added to concentrated $H_2SO_4$. The figures show a general increase, relative to FIGS. 2a and 2b, in the number of cracks and crevaces, i.e., in the amount of microcrazing, thus indicating an increase in surface area and the number of mechanical anchoring sites available for subsequent electroless metal plating.

Example 4

A sample of copper clad polysulfone circuit board (TEKCLAD® 1700) was drilled as in Example 1 and treated in concentrated (96%) $H_2SO_4$ as in Example 2. The board thus treated was then subjected while racked to the following sequence of activation and electroless copper plating steps:

1. Room temperature running water rinse for 1 minute;

2. Alkaline cleaning to remove oils (METEX® PTH Cleaner 9076, available from MacDermid, Inc.) at 60°C for 5 minutes;

3. Room temperature running water rinse for 3 minutes;

4. 10% $H_2SO_4$ rinse for 3 minutes at room temperature.

5. Etchant (available under the registered trademark CO-BRA ETCH from Electrochemicals, Inc.) to etch copper cladding only to ensure good electroless copper adhesion; etching for about 1.75 minutes at 55°C;

6. Room temperature running water rinse for 3 minutes;

7. Activation to electroless copper plating;

a. Activator predip (METEX® Pre-Dip 9008, available from MacDermid, Inc.) at room temperature for 5 minutes;

b. Activator dip (MACtivate 10 Activator, MacDermid, Inc.) for 5 minutes at 27°C with work agitation;

c. 2 minute room temperature running water rinse.

8. Exposure to electroless accelerator (METEX® PTH accelerator 9074, available from MacDermid, Inc.);

9. 2 minute room temperature running water rinse;

10. Electroless copper deposition (METEX® Electroless Copper 9048, MacDermid, Inc.) for 30 minutes at 55°C with work agitation;

11. 3 minute room temperature running water rinse;

12. Dipping in 5% $H_2SO_4$ for 30 seconds at room temperature;

13. Distilled water rinse at room temperature for 1 minute;

14. Dry board with compressed air.

Steps 1-14 represent a typical sequence for de-oiling, activating, and electrolessly copper plating hole walls in copper clad circuit boards. Similar regimens and accompanying activation chemicals are readily available from a number of manufacturers.

FIGS. 4a (X100) and 4b (X500) are SEMs which show the electroless copper plating and which enable a microscopic assessment of plating quality. The SEMs illustrate the appearance of a properly prepared and plated through hole in copper clad polysulfone. The hole wall presents a uniform appearance with no bubbles, blisters, voids, or other defects in the plating.

<u>Example 5</u>

A sample of copper clad polysulfone was drilled as in Example 1, and activated and electrolessly plated as described in Example 4, Steps 1-14. No treatment using concentrated $H_2SO_4$ or $H_2SO_4$/ammonium persulfate was employed as in Examples 2, 3, or 4, however.

FIGS. 5a (X100) and 5b (X500) are SEMS which show the electroless copper plating and which enable a microscopic assessment of plating quality. Particularly prominent is the presence of large circular voids where loosely adherent electroless copper has fallen free from the hole wall. The SEMs also illustrate a large amount of surface debris. These features are highly undesirable defects which prevent producing plated hole walls of good integrity.

Although only a few exemplary embodiments of this invention have been described in detail above, those skilled in the art will readily appreciate that many modifications are possible in the exemplary embodiments without materially departing from the novel teachings and advantages of this invention. Accordingly, all such modifications are intended to be included within the scope of this invention as defined in the following claims.

CLAIMS

1. A method of treating a copper clad thermoplastic laminate having holes drilled therein, comprising immersing the drilled laminate in concentrated sulfuric acid for a time sufficient to allow subsequent adherent electroless metal deposition on the hole walls thereof, and removing sulfuric acid from the laminate thus treated.

2. A method as claimed in claim 1, wherein said thermoplastic is selected from the group consisting of a polyarylate, a polyetherimide, a polyester polymer, an aromatic polycarbonate, a poly(aryl ether), a poly(aryl ether sulfone), or blends thereof.

3. A method as claimed in claim 2, wherein said polycarbonate is a polyestercarbonate.

4. A method as claimed in claim 2, wherein said polyetherimide has the formula:

(I) 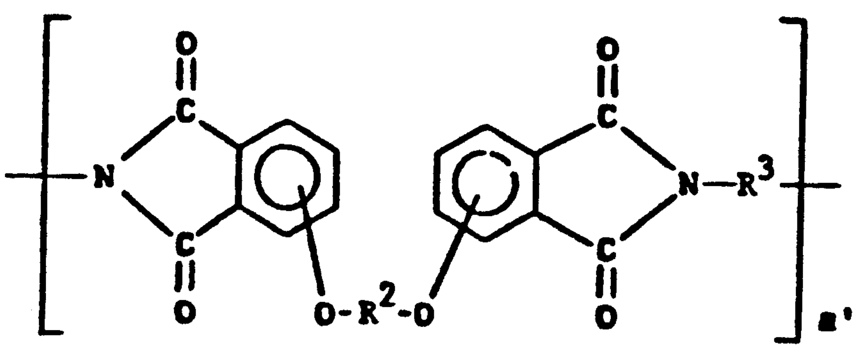

wherein

a' is an integer greater than 1, $-O-R^2-O-$ is attached to the 3 or 4 and 3' or 4' positions, $R^2$ is selected from (a) substituted or unsubstituted aromatic radicals having the formula

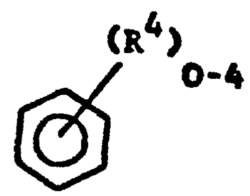

, or

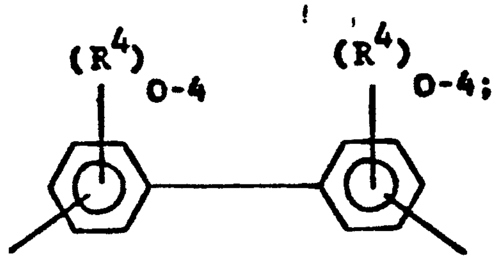

(b) divalent radicals of the formula:

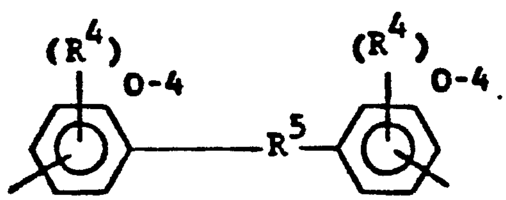

wherein $R^4$ is independently $C_1$ to $C_6$ alkyl, aryl or halogen and

$R^5$ is selected from -O-, -S-, $-\overset{O}{\overset{\|}{C}}-$, $-SO_2-$, -SO-, alkylene of 1 to 6 carbon atoms, cycloalkylene of 4 to 8 carbon atoms, alkylidene of 1 to 6 carbon atoms or cycloalkylidene of 4 to 8 carbon atoms, and

$R^3$ is selected from an aromatic hydrocarbon radicals having from 6 to 20 carbon atoms, halogenated derivatives thereof, alkyl

substituted derivatives thereof wherein the alkyl groups contains 1 to 6 carbon atoms, alkylene and cycloalkylene radicals having from 2 to 20 carbon atoms, $C_2$ to $C_8$ alkylene terminated polydiorganosiloxanes, and divalent radicals of the formula

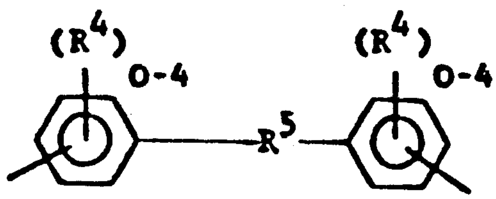

5. A method as claimed in claim 2, wherein said polyetherimide has the formula:

(II) 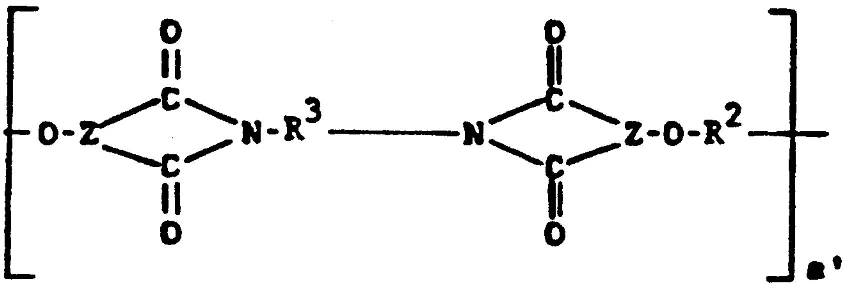

wherein -O-Z is a member selected from

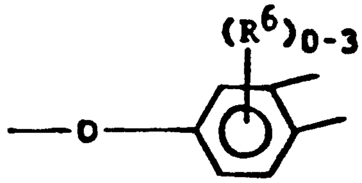

wherein $R^6$ is independently hydrogen, lower alkyl or lower alkoxy

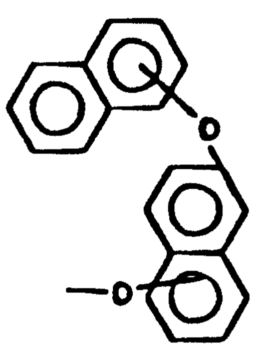

and,

wherein the oxygen may be attached to either ring and located ortho or para to one of the bonds of the imide carbonyl groups, $R^2$ and $R^3$ and a' are as previously defined.

6. A method as claimed in claim 2, wherein said polyester has the following general formula:

(VIII) 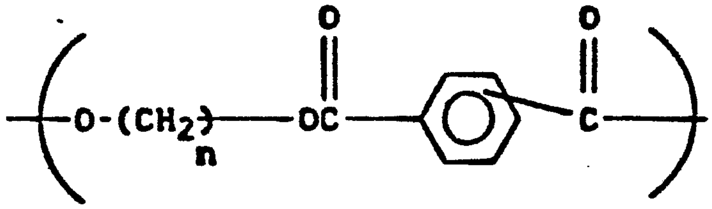

wherein n is an integer of from 2 to 10.

7. A method as claimed in claim 2, wherein said polyester has the following formula:

(IX) 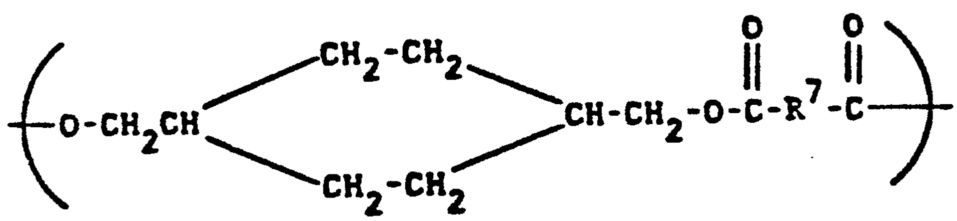

wherein the cyclohexane ring is selected from the cis- and trans- isomers thereof and $R^7$ represents an aryl radical containing 6 to 20 carbon atoms and which is the decarboxylated residue derived from an aromatic dicarboxylic acid.

8. A method as claimed in claim 2, wherein said poly(aryl ether) comprises repeat units of the formula:

-O-E-O-E'-

wherein E is the residuum of a dihydric phenol and E' is the residuum of a benzenoid compound having an inert electron withdrawing group in at least one of the positions ortho and para to the valence bonds, and wherein said residua are valently bonded to the ether oxygens -O- through aromatic carbon atoms.

9. A method as claimed in claim 2, wherein said poly(aryl ether) comprises repeating units of the formula:

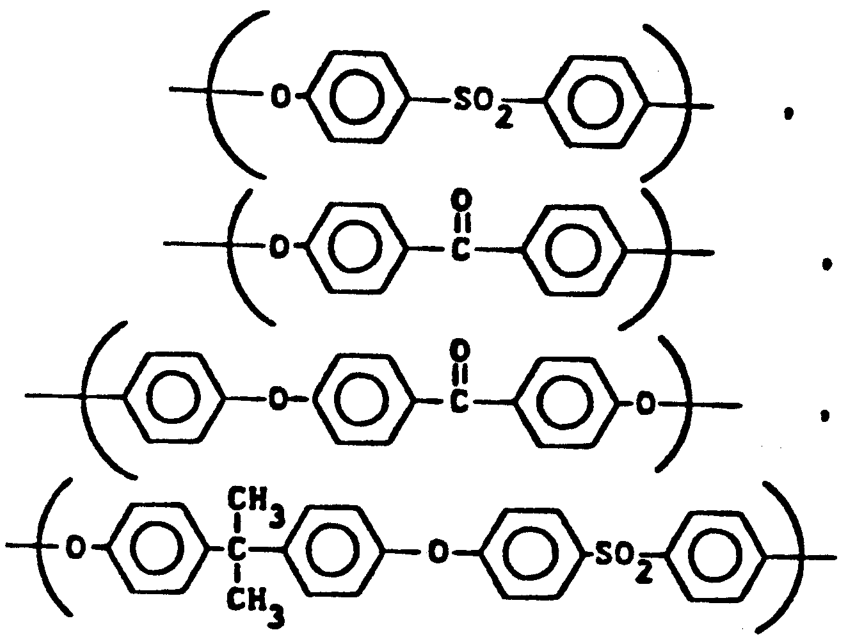

, , , and

10. A method as claimed in claim 2, wherein said poly(aryl ether sulfone) contains units of the formula:

(X) 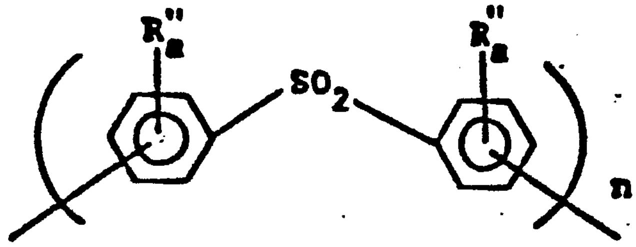 , and

(XI) 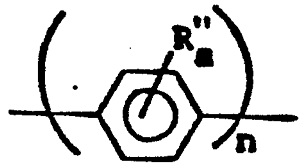

and/or

(XII) 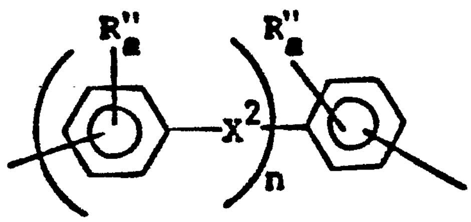

wherein

R" is independently hydrogen, $C_1$ to $C_6$ alkyl or $C_4$ to $C_8$ cycloalkyl,

$X^2$ is independently

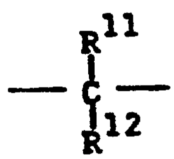

wherein $R^{11}$ and $R^{12}$ are independently hydrogen or $C_1$ to $C_9$ alkyl, or

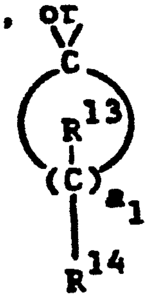

wherein $R^{13}$ and $R^{14}$ are independently hydrogen or $C_1$ to $C_8$ alkyl, and $a_1$ is an integer of 3 to

8; -S-, -O-, or 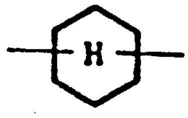,

a is an integer of 0 to 4,

n is independently an integer of 1 to 3,

the ratio of unit (X) to the sum of units (XI) and/or (XII) is greater than 1,and

said units are attached to each other by an -O- bond.

11. A method as claimed in claim 2, wherein said polyarylate is derived from a dihydric phenol reacted with an aromatic dicarboxylic acid.

12. A method as claimed in any one of claims 2 to 11 wherein said thermoplastic contains, blended therewith, at least one member selected from the group consisting of polyamides, polyphenylenesulfides, and poly(aryl ether ketones) in an amount up to about 50 wt. % based on the weight of the blend.

13. A method as claimed in any one of the preceding claims wherein said sulfuric acid contains a dissolved oxidizing agent.

14. A method as claimed in claim 13, wherein said oxidizing agent is ammonium persulfate.

15. A method as claimed in claim 13 or claim 14 wherein said oxidizing agent is present in an amount between about 0.05 and about 1 mole per liter of concentrated sulfuric acid.

16. A method as claimed in anv one of preceding claims wherein said electroless metal is copper.

17. A method as claimed in anv one of the preceding claims wherein said laminate is treated for between about 0.5 and about 20 minutes.

18. A method as claimed in claim 13, wherein said laminate is treated for between about 15 seconds and about 10 minutes.

19. A method as claimed in anv one of the preceding claims wherein said laminate is treated at a temperature between about 10°C and about 50°C.

20. A drilled copper clad thermoplastic laminate when ever treated by a method as claimed in any one of the preceding claims.

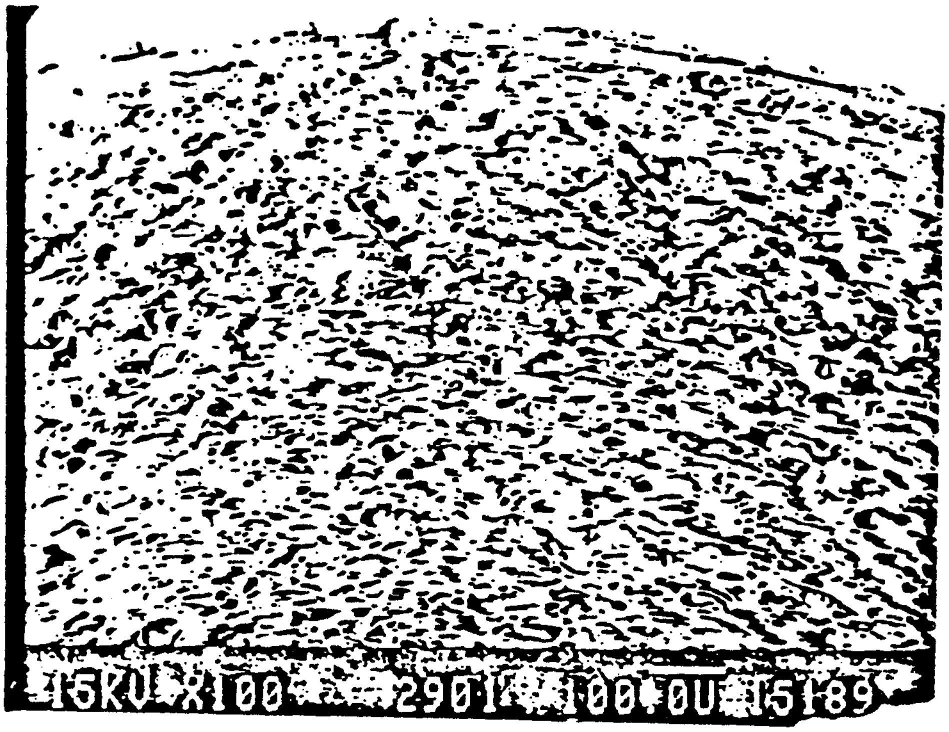


Fig. 1a

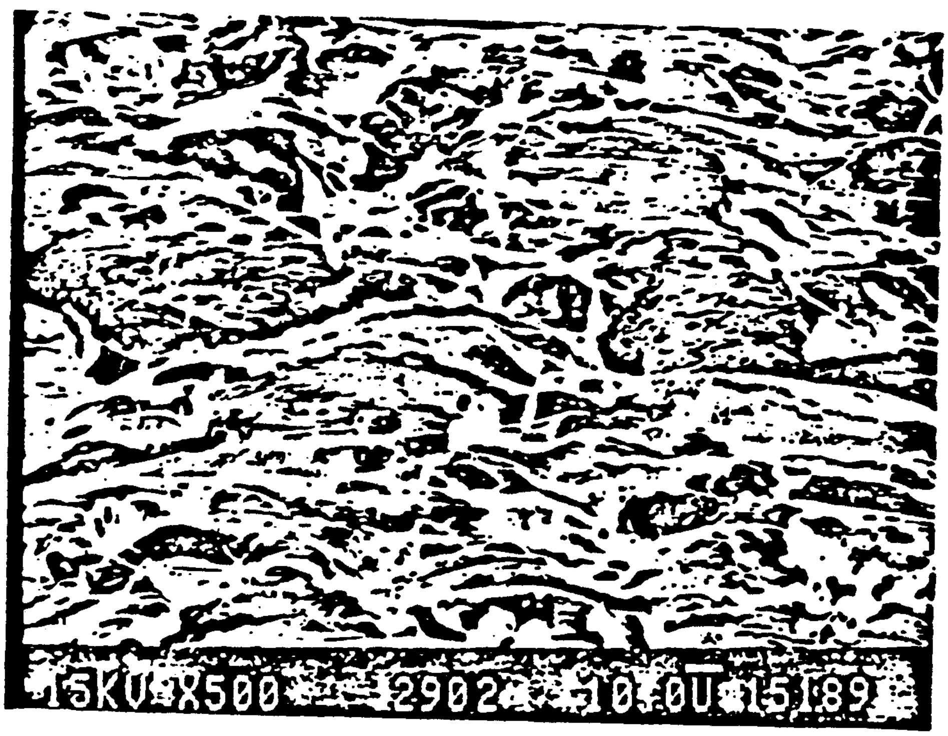


Fig. 1b

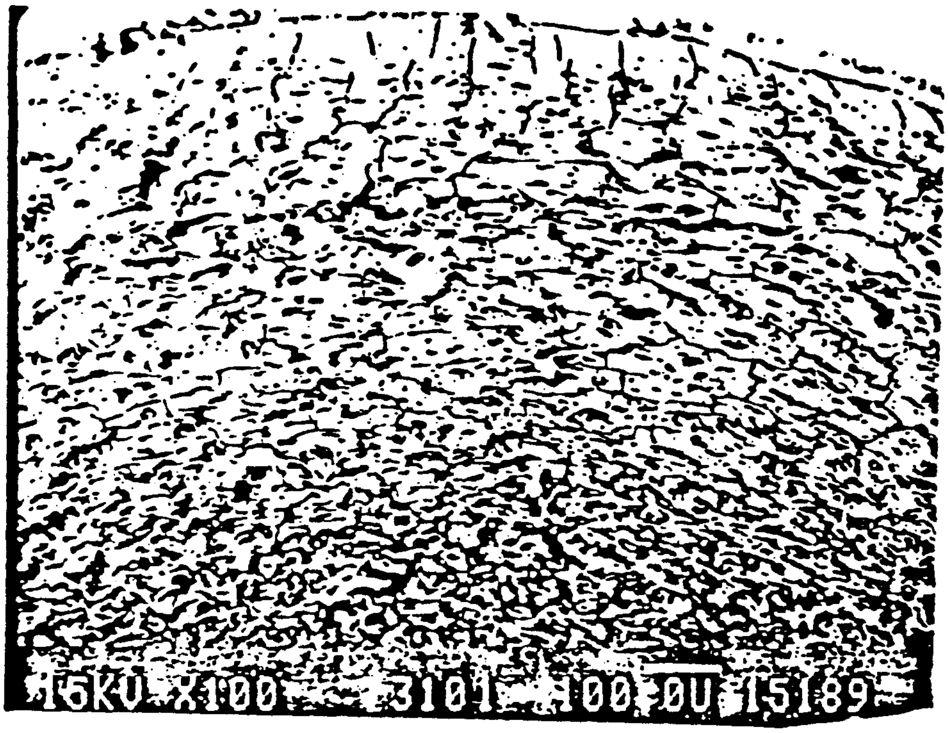


Fig. 2a

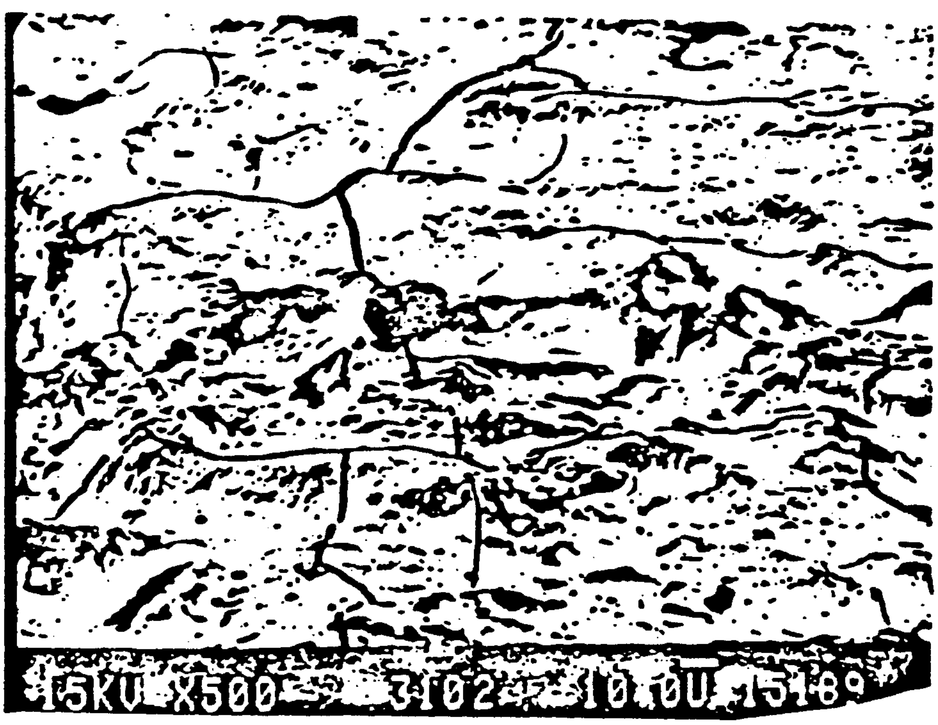


Fig. 2b

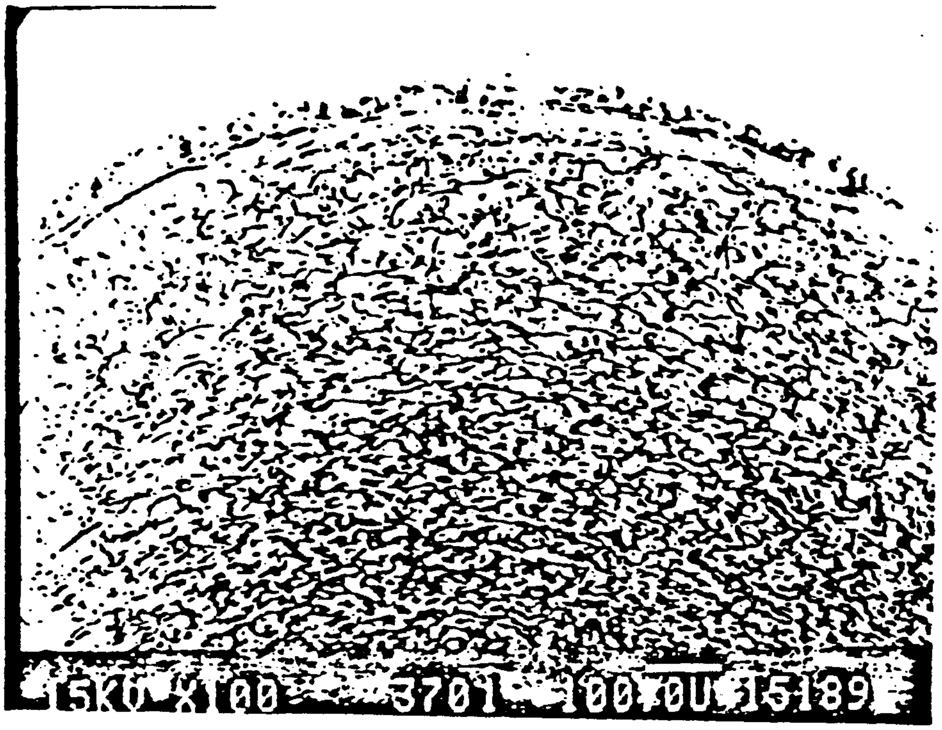


Fig. 3a

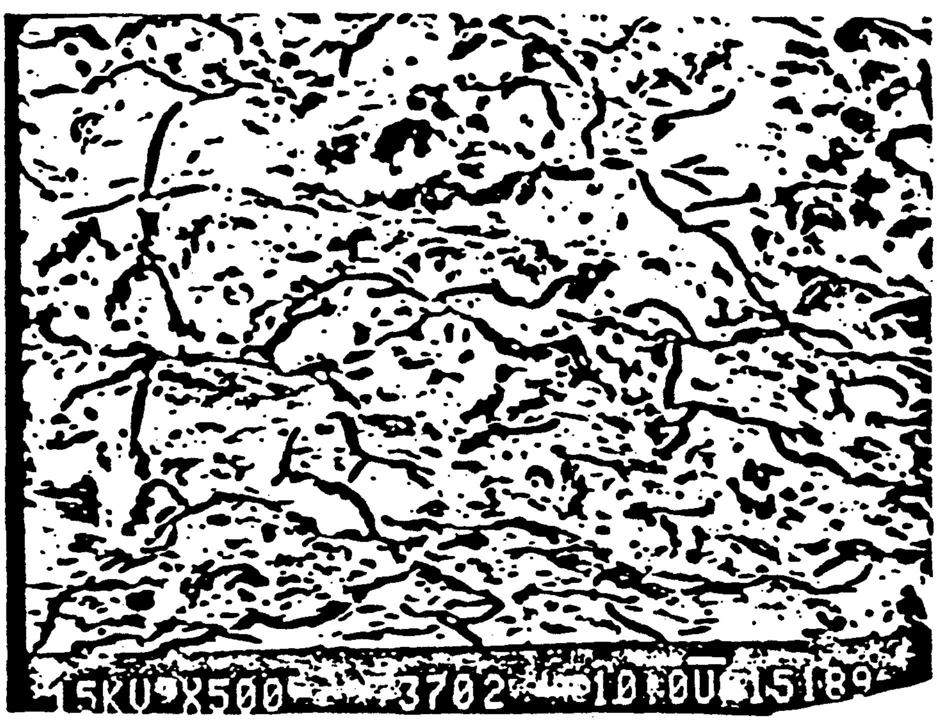


Fig. 3b

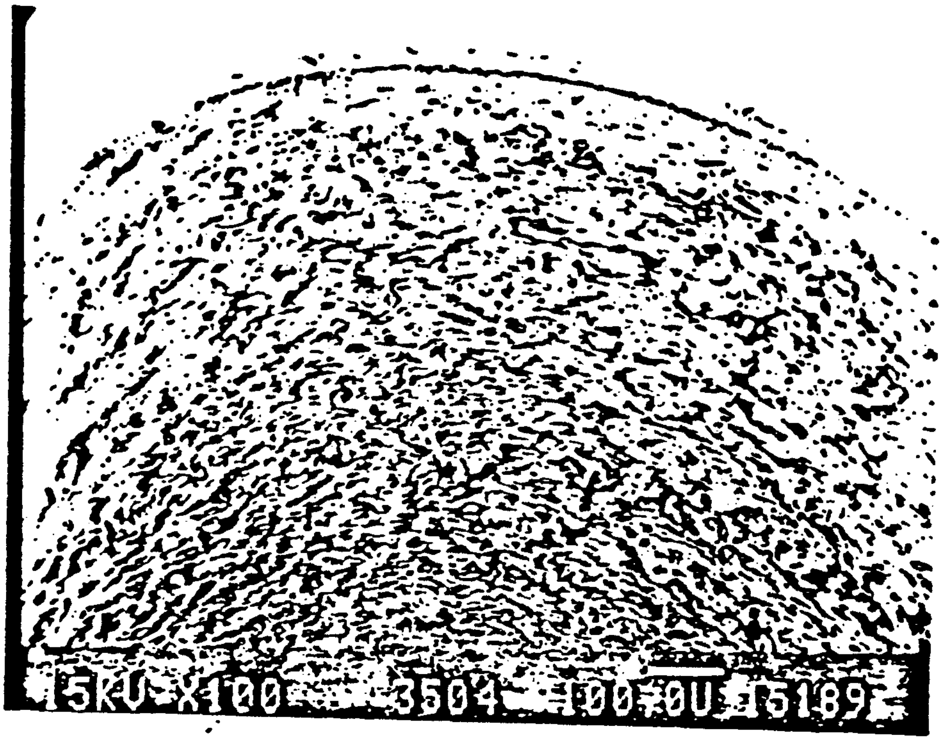


Fig. 4a

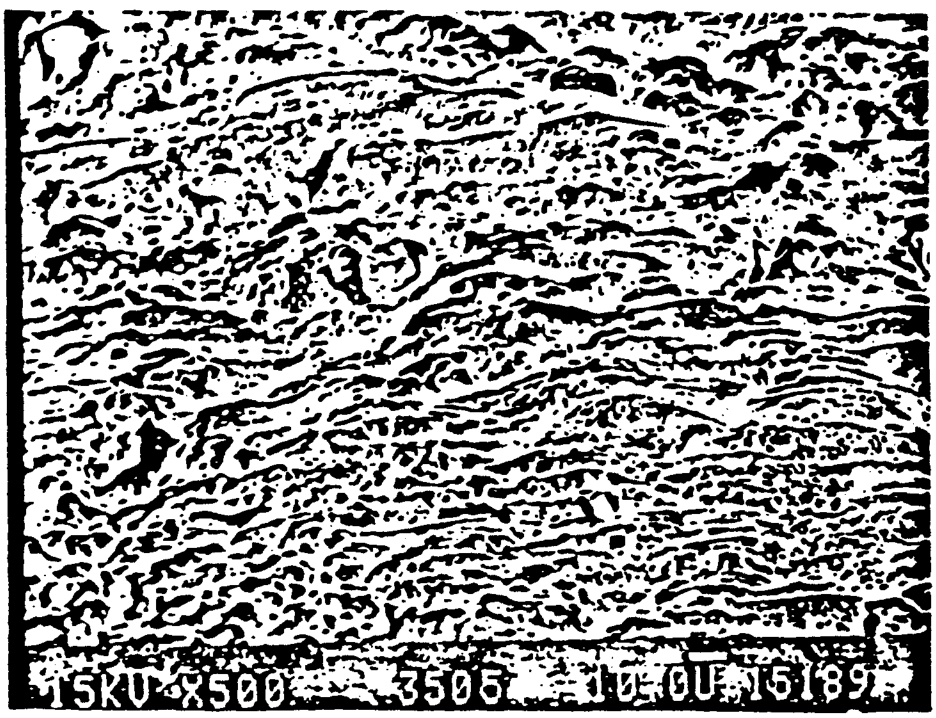


Fig. 4b

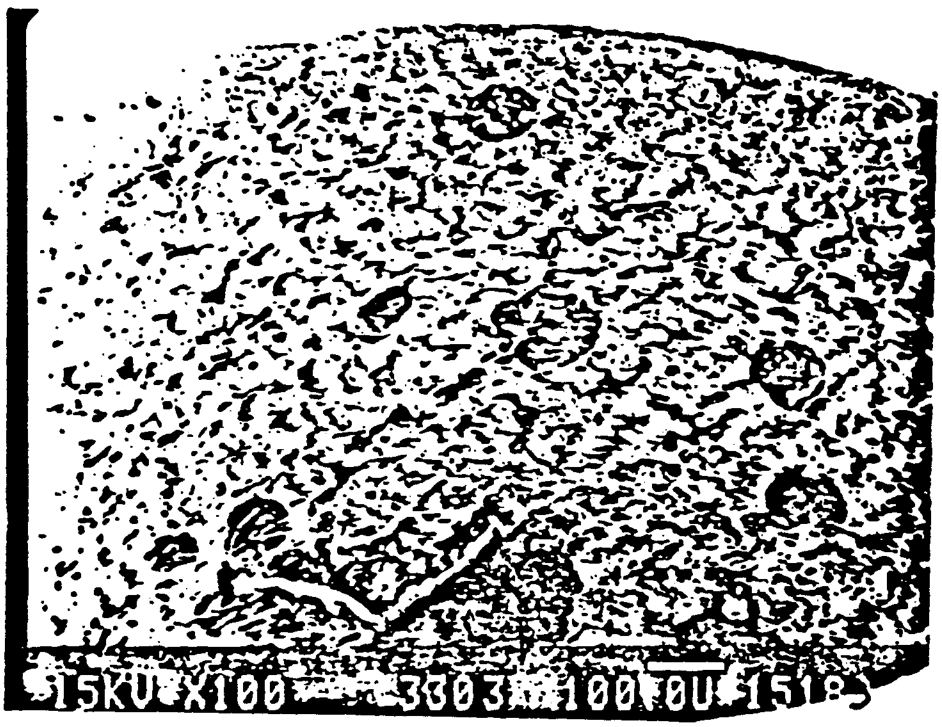


Fig. 5a

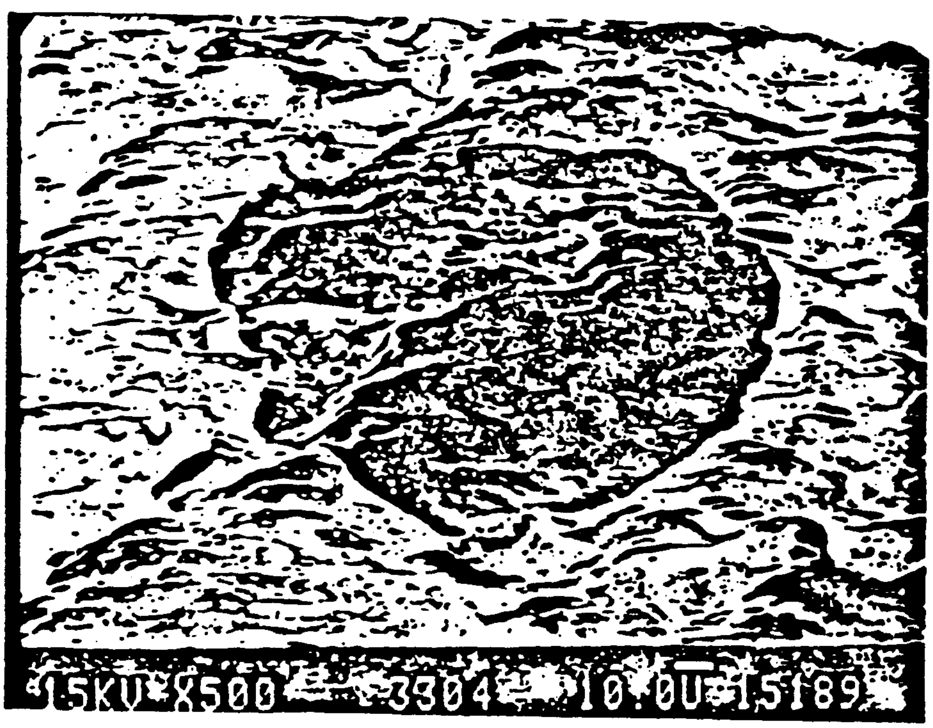


Fig. 5b